# EUROPEAN PATENT APPLICATION

(11) **EP 4 730 965 A2**
(43) Date of publication of application: **22.04.2026**
(21) Application number: 25205198.2
(22) Date of filing: 29.09.2025
(51) Int. Cl.: H10H 29/02, H10P 72/00, H10P 72/50

(54) **LIGHT EMITTING ELEMENT TRANSFER SYSTEM AND METHOD THEREOF**

(30) Priority: 30.09.2024 KR 20240132407
(71) Applicant: Samsung Display Co., Ltd., Yongin-si, Gyeonggi-do 17113 (KR)
(72) Inventor: Han, Jeong Won, Yongin-si, Gyeonggi-do (KR); Kim, Gil Jun, Yongin-si, Gyeonggi-do (KR); Lee, Jin Pyung, Yongin-si, Gyeonggi-do (KR)
(74) Representative: Gulde & Partner

(57) **Abstract**

A light emitting element transfer system includes: a vacuum chamber (VC) for creating a vacuum atmosphere or removing the vacuum atmosphere therein, an alignment portion (300) for aligning a first substrate (TS) and a second substrate (DS) inside the vacuum chamber (VC), a bonding portion (400) for applying heat and pressure to the aligned first substrate (TS) and second substrate (DS) and which is disposed adjacent to the alignment portion (300) in an arrangement direction (DR1) and inside the vacuum chamber (VC), and a first transfer portion (500) movable in the vacuum chamber (VC) the arrangement direction (DR1), for transferring the first substrate (TS) or the second substrate (DS) to the alignment portion (300), and for transferring the aligned first substrate (TS) and second substrate (DS) from the alignment portion (300) to the bonding portion (400).

## Description

### 1. Field

The present disclosure relates to a light emitting element transfer system and transfer method.

### 2. Description of the Related Art

The importance of display devices is increasing along with the development of multimedia. In response to this, various types of display devices such as organic light emitting display devices (OLED) and liquid crystal display devices (LCD), etc. are being used.

A display panel such as a light emitting display panel or a liquid crystal display panel is included as a device that displays an image of a display device. Among them, the light emitting display panel may include a light emitting diode (LED), and as a light emitting diode, an organic light emitting diode that uses an organic substance as a fluorescent material or an inorganic light emitting diode that uses an inorganic substance as a fluorescent material is included.

When manufacturing a display panel that uses an inorganic light emitting diode as a light emitting diode, transfer equipment for transferring micro LED devices onto the substrate of the display panel must be developed.

### SUMMARY

Aspects and features of embodiments of the present disclosure are to provide a light emitting element transfer system capable of performing an accurate alignment process and a bonding process in the same chamber.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

The invention is defined by the appended set of claims. The description that follows is subjected to this limitation. Any disclosure lying outside the scope of said claims is only intended for illustrative as well as comparative purposes.

According to an embodiment, a light emitting element transfer system includes: a vacuum chamber for creating a vacuum atmosphere or removing the vacuum atmosphere therein, an alignment portion for aligning a first substrate and a second substrate inside the vacuum chamber, a bonding portion for applying heat and pressure to the aligned first substrate and second substrate and which is disposed adjacent to the alignment portion in a an arrangement direction and inside the vacuum chamber, and a first transfer portion movable in the vacuum chamber in the arrangement direction, for transferring the first substrate or the second substrate to the alignment portion, and transferring the aligned first substrate and second substrate from the alignment portion to the bonding portion.

The bonding portion may be disposed directly adjacent to the alignment portion.

The alignment portion may include a stage module having a holding mechanism for preventing movement of the first substrate or a tray on a top surface thereof and a protruding and concealable protruding member, and for supporting the first substrate during an alignment process, a holding member disposed on a top portion of the stage module and for adsorbing or gripping a back surface of the second substrate to support the second substrate on a top portion of the first substrate, a second driving member for moving the holding member in a horizontal direction and a vision member for photographing an alignment of the first substrate and the second substrate.

The holding mechanism may be disposed directly on the top surface of the stage module of the alignment portion. The holding member may be disposed vertically (i.e., the third direction DR3) above the stage module of the alignment portion and disposed to overlap the stage module of the alignment portion in a plan view. The stage module may include a first driving member. The stage module may include a lifting member.

The stage module may be a UVW stage, and the first transfer portion may be a vacuum robot.

The vacuum robot may include a dual arm.

The bonding portion may include: a stage module including a holding mechanism, a protruding member, and a heater; a lifting member for vertically elevating and lowering the stage module; a pressure member disposed on the stage module and for pressing the second substrate disposed on the stage module and for transmitting laser light; and a laser member for emitting the laser light from above the pressure member to the second substrate disposed on the stage module.

The bonding portion may include: a heating stage including a holding mechanism, a protruding member, and a heater; a lifting member configured to vertically elevate and lower the heating stage; a pressure member disposed on the heating stage and configured to press the second substrate disposed on the heating stage and to transmit laser light; and a laser member configured to emit the laser light from above the pressure member to the second substrate disposed on the heating stage.

The pressure member may be disposed vertically (i.e., the third direction DR3) above the stage module of the bonding portion and disposed to overlap the stage module of the bonding portion in a plan view. The pressure member may be disposed vertically (i.e., the third direction DR3) above the heating stage of the bonding portion and disposed to overlap the heating stage of the bonding portion in a plan view.

The system may further include a loading portion disposed inside the vacuum chamber and into which a substrate or a tray is loaded.

The loading portion may include: a first loading portion into which the first substrate or a first tray including the first substrate is loaded; and a second loading portion into which a second tray including the second substrate is loaded, where the substrate includes the first substrate and the second substrate, and the tray includes the first tray and the second tray.
The vacuum chamber may include a chamber door located on one side, and wherein trays on which the first substrate or the second substrate are disposed may enter and exit the vacuum chamber through the chamber door.

The vacuum chamber may include a chamber door located only on one side of the vacuum chamber.

The system may further include a cassette disposed outside the vacuum chamber and for loading a tray on which the first substrate or the second substrate is placed and a second transfer portion disposed outside the vacuum chamber and for transferring the tray loaded in the cassette into the vacuum chamber.

According to an embodiment, a light emitting element transfer system may include: a vacuum chamber for creating a vacuum atmosphere or removing the vacuum atmosphere therein; an alignment portion for aligning a first substrate and a second substrate inside the vacuum chamber; a bonding portion for applying heat and pressure to the aligned first substrate and second substrate and which is disposed adjacent to the alignment portion in a an arrangement direction and inside the vacuum chamber; and a stage module for movably being disposed between the alignment portion and the bonding portion, and including a stage including a heater, and a stage driving portion for driving the stage.

The stage may further include a holding mechanism for preventing movement of the first or second substrates or a tray on a top surface thereof, and a protruding and concealable protruding member.

The alignment portion may include a holding member disposed on an upper portion of the stage module and for adsorbing or gripping a back surface of the second substrate to support the second substrate on an upper portion of the first substrate, a second driving member, which moves the holding member in a horizontal direction and a vision member, which photographs an alignment of the first substrate and the second substrate.

The bonding portion may include: a pressure plate, which transmits laser light; a support portion, which supports the pressure plate; a pressure driving portion, which vertically raises and lowers the pressure plate; a window, which overlaps the pressure plate, transmits the laser light, and is disposed on a ceiling of the vacuum chamber; and a laser member, which emits the laser light from above the window.

The stage module may further include a first lifting member, which vertically raises and lowers the stage.

The alignment portion further includes a second lifting member, which vertically raises and lowers the holding member.

According to an embodiment, a transfer method for light emitting elements includes: loading a first tray on which a first substrate is disposed and a second tray on which a plurality of second substrates are disposed, into a vacuum chamber by a second transfer portion; making an inside of the vacuum chamber into a vacuum state; transferring the first tray and the second tray to an alignment portion' aligning and bonding the plurality of second substrates disposed on the second tray one by one to the first substrate disposed on the first tray in the alignment portion; transferring the first tray on which the first substrate bonded to the second substrates is disposed, to a bonding portion by a first transfer portion; applying heat and pressure to the first substrate bonded to the second substrates in the bonding portion to bond the light emitting elements disposed on the second substrate to the first substrate; and the removing the vacuum atmosphere from the vacuum chamber.

The transferring to the alignment portion may include: disposing the first tray on a UVW stage of the alignment portion; and adsorbing or gripping a second substrate of one of the plurality of second substrates disposed on the second tray with a holding member.

The aligning and bonding may include: adsorbing the first tray on a top surface of the UVW stage using a holding mechanism; moving the UVW stage while lowering the holding member to align the first tray and the second tray; and causing a second holding member to stop adsorbing or gripping the second substrate to bond the second substrate onto the first substrate.

According to an embodiment, a transfer method for light emitting elements includes: loading a first substrate and a second tray on which a plurality of second substrates are disposed into a vacuum chamber by a second transfer portion; making a vacuum state inside the vacuum chamber; transferring the first substrate and the second tray to an alignment portion by a first transfer portion; aligning and bonding the plurality of second substrates disposed on the second tray to the first substrate one by one in the alignment portion; transferring the first substrate bonded to the second substrate to a bonding portion by the first transfer portion; applying heat and pressure to the first substrate bonded to the second substrates in the bonding portion to bond the light emitting elements disposed on the second substrate to the first substrate; and removing the vacuum atmosphere from the vacuum chamber.

According to an embodiment, a transfer method for light emitting elements includes: loading a first tray on which a first substrate is disposed and a second tray on which a plurality of second substrates are disposed into a stage module of a vacuum chamber by a second transfer portion; making a vacuum state inside the vacuum chamber; moving a stage on which the first tray and the second tray are disposed by the stage module to an alignment area; adsorbing or gripping the plurality of second substrates disposed on the second tray one by one by a holding member of the alignment area to align and bond the second substrates onto the first substrate; transferring the stage to a bonding area by the stage module; applying heat and pressure to the first substrate bonded to the second substrates in the bonding area to bond the first substrate and the light emitting elements disposed on the second substrate; and removing the vacuum atmosphere from the vacuum chamber.

The applying of the heat and the pressure may include: heating an embedded heater; irradiating a laser onto the first substrate in the bonding area; and pressurizing the first substrate bonded to the second substrate by lowering a pressure member in the bonding area.

According to one embodiment of the disclosure, the light emitting element transfer system may continuously perform the alignment process and the bonding process in a high vacuum environment without opening the vacuum chamber, thereby increasing the production efficiency of the transfer device.

In addition, since the alignment process and the bonding process may be performed in a high vacuum environment, the penetration of moisture or oxygen into the light emitting element of the target substrate may be effectively minimized. Therefore, the reliability of the element of the target substrate, i.e., the display device, may be improved.

However, the effects of the present disclosure are not limited to the aforementioned effects, and various other effects are included in the present specification.

### BRIEF DESCRIPTION OF THE DRAWINGS

FIG. 1 is a layout diagram illustrating a display device according to one embodiment.
FIG. 2 is an exemplary diagram illustrating an example of a pixel of FIG. 1.
FIG. 3 is an exemplary diagram illustrating another example of a pixel of FIG. 1.
FIG. 4 is a cross-sectional view illustrating an example of a display panel cut along line A-A' of FIG. 2.
FIG. 5 is a schematic plan view of a light emitting element transfer system according to one embodiment.
FIG. 6 is a schematic side view of a light emitting element transfer system according to one embodiment.
FIGS. 7 and 8 are enlarged views of the loading portion according to the embodiment of FIGS. 5 and 6.
FIGS. 9 and 10 are enlarged views of the loading portion according to another embodiment of FIGS. 7 and 8.
FIG. 11 is a schematic plan view illustrating a light emitting element transfer system according to another embodiment.
FIG. 12 is a side view of the light emitting element transfer system of FIG. 11.
FIG. 13 is a schematic plan view of a light emitting element transfer system according to another embodiment.
FIG. 14 is a side view of the light emitting element transfer system of FIG. 13.
FIG. 15 is a schematic plan view illustrating a light emitting element transfer system according to another embodiment.
FIG. 16 is a side view of the light emitting element transfer system of FIG. 15.
FIG. 17 is a schematic plan view illustrating a light emitting element transfer system according to another embodiment.
FIG. 18 is a side view of the light emitting element transfer system of FIG. 17.
FIG. 19 is a perspective view to illustrate the configuration of the first transfer portion.
FIG. 20 is a plan view schematically illustrating a light emitting element transfer system according to another embodiment.
FIG. 21 is a side view of the light emitting element transfer system of FIG. 20.
FIG. 22 is a plan view schematically illustrating a light emitting element transfer system according to another embodiment.
FIG. 23 is a side view of the light emitting element transfer system of FIG. 22.
FIG. 24 is a schematic plan view illustrating a light emitting element transfer system according to another embodiment.
FIG. 25 is a side view of the light emitting element transfer system of FIG. 24.
FIG. 26 is a schematic plan view illustrating a light emitting element transfer system according to another embodiment.
FIG. 27 is a side view of the light emitting element transfer system of FIG. 26.
FIG. 28 is a flow chart to illustrate a light emitting element transfer method using a transfer device according to one embodiment.
FIG. 29 is a flow chart to illustrate a light emitting element transfer method using a transfer device according to one embodiment.
FIG. 30 is an exemplary drawing illustrating a smart watch including a display device according to one embodiment.
FIGS. 31 and 32 are exemplary drawings illustrating a virtual reality device including a display device according to one embodiment.
FIG. 33 is an exemplary drawing illustrating a virtual reality device including a display device according to another embodiment.
FIG. 34 is an exemplary drawing illustrating a vehicle instrument panel and center fascia including display devices according to one embodiment.
FIG. 35 is an exemplary drawing illustrating a transparent display device including a display device according to one embodiment.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the present disclosure. In the accompanying figures, the thickness of layers and regions may be exaggerated for clarity.

Some of the parts which are not associated with the description may not be provided in order to describe embodiments of the present disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above (i.e., third direction DR3), and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

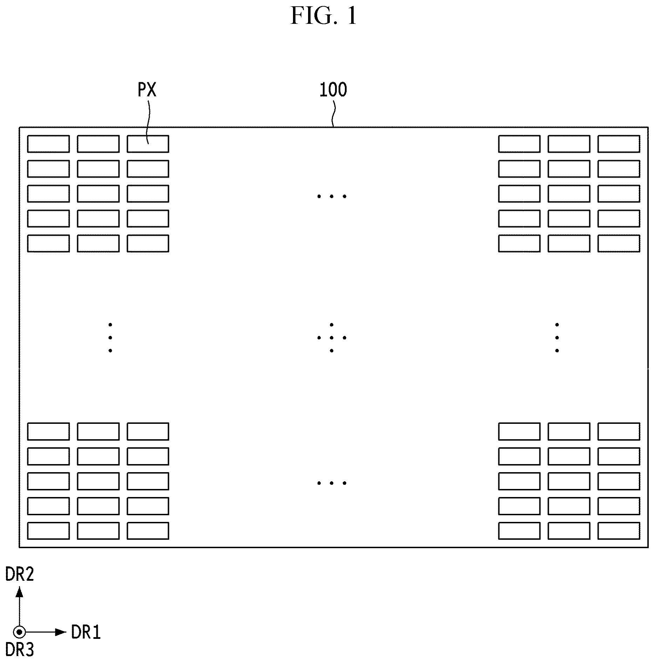

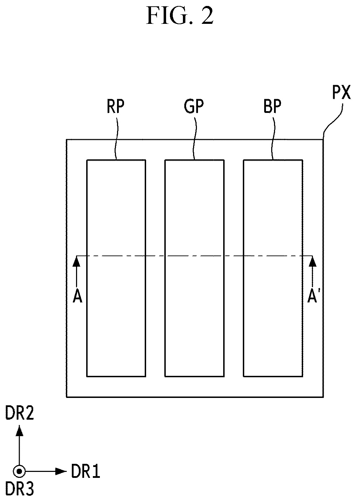

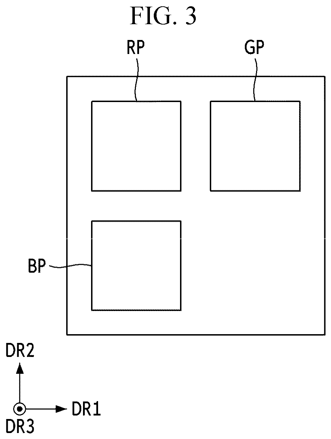

FIG. 1 is a layout diagram illustrating a display device according to one embodiment. FIG. 2 is an exemplary diagram illustrating an example of a pixel of FIG. 1. FIG. 3 is an exemplary diagram illustrating another example of a pixel of FIG. 1.

Referring to FIGS. 1 to 3, a display device 10 is a device for displaying video or still images, such as mobile phones, smart phones, tablet personal computers , and portable electronic devices such as smart watches, watch phones, mobile communication terminals, electronic notebooks, e-books, portable electronic devices such as portable multimedia players (PMP), navigation, and ultra mobile PCs (UMPC), as well as display screens for a variety of products such as televisions, laptops, monitors, billboards, and the internet of things (IOT).

The display device 100 may be formed as a rectangular plane having a long side in a first direction DR1 and a short side in a second direction DR2 intersecting the first direction DR1. A corner where the long side in the first direction DR1 and the short side in the second direction DR2 meet may be formed rounded to have a predetermined curvature or formed at a right angle. The planar shape of the display device 100 is not limited to a rectangle, and may be formed in other polygonal, circular, or oval shapes. The display device 100 may be formed flat but is not limited thereto. For example, the display device 100 is formed at left and right ends and may include curved portions with a constant curvature or a changing curvature. Additionally, the display device 100 may be formed to be flexible, such as to be able to be bent, curved, bent, folded, or rolled.

The display device 100 may further include pixels PX for displaying an image, scan lines extending in the first direction DR1, and data lines extending in the second direction DR2. The pixels PX may be disposed in a matrix form in the first direction DR1 and the second direction DR2.

Each of the pixels PX may include a plurality of sub-pixels RP, GP, and BP as shown in FIGS. 2 and 3. In FIGS. 2 and 3, each of the pixels PX includes three sub-pixels RP, GP, and BP, that is, a first sub-pixel RP, a second sub-pixel GP, and a third sub-pixel BP, but the embodiment of the present disclosure is not limited thereto.

The first sub-pixel RP, the second sub-pixel GP, and the third sub-pixel BP may be connected to one of the data lines and at least one scan line among the scan lines.

Each of the first sub-pixel RP, the second sub-pixel GP, and the third sub-pixel BP may have a planar shape of a rectangle, a square, or a rhombus. For example, each of the first sub-pixel RP, the second sub-pixel GP, and the third sub-pixel BP may have a planar shape of a rectangle having a short side in the first direction DR1 and a long side in the second direction DR2, as shown in FIG. 2. Alternatively, each of first sub-pixel RP, the second sub-pixel GP, and the third sub-pixel BP may have a planar shape of a square or a rhombus including sides having the same length in the first direction DR1 and the second direction DR2, as shown in FIG. 3.

As shown in FIG. 2, the first sub-pixel RP, the second sub-pixel GP, and the third sub-pixel BP may be disposed in the first direction DR1. Alternatively, one of the second sub-pixel GP and the third sub-pixel BP and the first sub-pixel RP may be disposed in the first direction DR1, and the other one and the first sub-pixel RP may be disposed in the second direction DR2. For example, as shown in FIG. 3, the first sub-pixel RP and the second sub-pixel GP may be disposed in the first direction DR1, and the first sub-pixel RP and the third sub-pixel BP may be disposed in the second direction DR2.

Alternatively, one of the first sub-pixel RP and the third sub-pixel BP and the second sub-pixel GP may be disposed in the first direction DR1, and the other one and the second sub-pixel GP may be disposed in the second direction DR2. Alternatively, one of the first sub-pixel RP and the second sub-pixel GP and the third sub-pixel BP may be disposed in the first direction DR1, and the remaining one and the third sub-pixel BP may be disposed in the second direction DR2.

The first sub-pixel RP may include a first light emitting element that emits first light, the second sub-pixel GP may include a second light emitting element that emits second light, and the third sub-pixel BP may include a third light emitting element that emits third light. Here, the first light may be light in a red wavelength band, the second light may be light in a green wavelength band, and the third light may be light in a blue wavelength band. The red wavelength band may be a wavelength band of about 600 nanometers (nm) to 750 nm, the green wavelength band may be a wavelength band of about 480 nm to 560 nm, and the blue wavelength band may be a wavelength band of about 370 nm to 460 nm, but the embodiments of the present disclosure are not limited thereto.

Each of the first sub-pixel RP, the second sub-pixel GP, and the third sub-pixel BP may include an inorganic light emitting element having an inorganic semiconductor as a light emitting element that emits light. For example, the inorganic light emitting element may be a micro LED (Light Emitting Diode) of a flip-chip type, but the embodiment of the present disclosure is not limited thereto.

As shown in FIGS. 2 and 3, the area of the first sub-pixel RP, the area of the second sub-pixel GP, and the area of the third sub-pixel BP may be substantially the same, but the embodiment of the present disclosure is not limited thereto. At least one of area of the first sub-pixel RP, the area of the second sub-pixel GP, and the area of the third sub-pixel BP may be different from another one. Alternatively, any two of the area of area of the first sub-pixel RP, the area of the second sub-pixel GP, and the area of the third sub-pixel BP may be substantially the same, and the remaining one may be different from the two. Alternatively, the area of the first sub-pixel RP, the area of the second sub-pixel GP, and the area of the third sub-pixel BP may be different from each other.

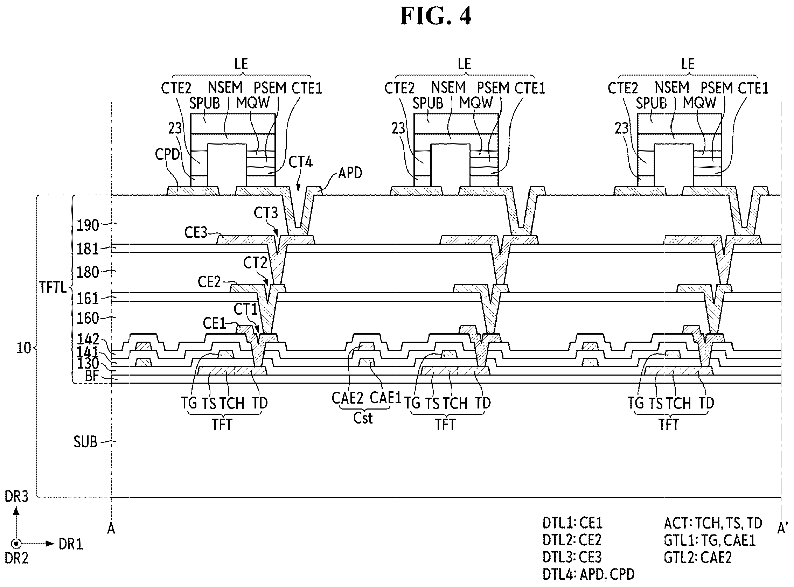

FIG. 4 is a cross-sectional view illustrating an example of a display panel cut along line A-A' of FIG. 2.

Referring to FIG. 4, the display device 100 may include a thin film transistor layer TFTL and light emitting elements LE disposed on a substrate SUB. The thin film transistor layer TFTL may be a layer on which thin film transistors TFT are formed.

The thin film transistor layer TFTL may include an active layer ACT, a first gate layer GTL1, a second gate layer GTL2, a first data metal layer DTL1, a second data metal layer DTL2, a third data metal layer DTL3, and a fourth data metal layer DTL4. Further, the thin film transistor layer TFTL includes a buffer film BF, a gate insulating film 130, a first interlayer insulating film 141, a second interlayer insulating film 142, a first planarization film 160, a first insulating film 161, a second planarization film 180, and a second insulating film 181.

The substrate SUB may be a base substrate or a base member for supporting a display device. The substrate SUB may be a rigid substrate made of glass, but the embodiments of the present disclosure are not limited thereto. The substrate SUB may be a flexible substrate capable of bending, folding, rolling, etc. In this case, the substrate SUB may include an insulating material such as a polymer resin such as polyimide (PI).

A buffer film BF may be disposed on one surface of the substrate SUB. The buffer film BF may be a film for preventing the penetration of air or moisture. The buffer film BF may be formed of a plurality of inorganic films alternately laminated. For example, the buffer film BF may be formed as a multilayer of alternately stacked inorganic films of one or more of a silicon nitride layer, a silicon oxynitride layer, a silicon oxide layer, a titanium oxide layer, and an aluminum oxide layer. The buffer film BF may be omitted.

An active layer ACT may be disposed on the buffer film BF. The active layer ACT may include a silicon semiconductor, such as polycrystalline silicon, monocrystalline silicon, low-temperature polycrystalline silicon, and amorphous silicon, or may comprise an oxide semiconductor.

The active layer ACT may include a channel TCH, a first electrode TS, and a second electrode TD of a thin film transistor TFT. The channel TCH of the thin film transistor TFT may be an area overlapping with a gate electrode TG of the thin film transistor TFT in the third direction DR3 that is a thickness direction of the substrate SUB. The first electrode TS of the thin film transistor TFT may be disposed on one side of the channel TCH, and the second electrode TD may be disposed on the other side of the channel TCH. The first electrode TS and the second electrode TD of the thin film transistor TFT may be areas that do not overlap with the gate electrode TG in the third direction DR3. The first electrode TS and the second electrode TD of the thin film transistor TFT may be areas in which ions are doped in a silicon semiconductor or an oxide semiconductor to have conductivity.

A gate insulating film 130 may be disposed on the active layer ACT. The gate insulating film 130 may be formed of an inorganic film, such as a silicon nitride layer, a silicon oxynitride layer, a silicon oxide layer, a titanium oxide layer, or an aluminum oxide layer.

A first gate layer GTL1 may be disposed on the gate insulating film 130. The first gate layer GTL1 may include the gate electrode TG of the thin film transistor TFT and the capacitor electrode Cst. The first gate layer GTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first interlayer insulating film 141 may be disposed on the first gate layer GTL1. The first interlayer insulating film 141 may be formed of an inorganic film, such as a silicon nitride layer, a silicon oxynitride layer, a silicon oxide layer, a titanium oxide layer, or an aluminum oxide layer.

A second gate layer GTL2 may be disposed on the first interlayer insulating film 141. The second gate layer GTL2 may include a second capacitor electrode CAE2 of the capacitor Cst. The second gate layer GTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second interlayer insulating film 142 may be disposed on the second gate layer GTL2. The second interlayer insulating film 142 may be formed of an inorganic film, such as a silicon nitride layer, a silicon oxynitride layer, a silicon oxide layer, a titanium oxide layer, or an aluminum oxide layer.

A first data metal layer DTL1 including a first connection electrode CE1, a first sub-pad, and a data line may be disposed on the second interlayer insulating film 142. The data line may be formed integrally with the first sub-pad, but the embodiment of the present disclosure is not limited thereto. The first data metal layer DTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first connection electrode CE1 may be connected to the first electrode TS or the second electrode TD of the thin film transistor TFT through the first contact hole CT1 penetrating the first interlayer insulating film 141 and the second interlayer insulating film 142.

A first planarization film 160 may be disposed on the first data metal layer DTL1 to planarize the step caused by the active layer ACT, the first gate layer GTL1, the second gate layer GTL2, and the first data metal layer DTL1. The first planarization film 160 may be formed from an organic film such as an acrylic resin, an epoxy resin, a phenolic resin, a polyamide resin, a polyimide resin, or the like.

A second data metal layer DTL2 may be disposed on the first planarization film 160. The second data metal layer DTL2 may include a second connection electrode CE2 and a second sub-pad . The second connection electrode CE2 may be connected to the first connection electrode CE1 through a second contact hole CT2 penetrating the first insulating film 161 and the first planarization film 160. The second data metal layer DTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second data metal layer DTL2. The second planarization film 180 may be formed of an organic film, such as an acrylic resin, an epoxy resin, a phenolic resin, a polyamide resin, a polyimide resin, or the like.

A third data metal layer DTL3 may be disposed on the second planarization film 180. The third data metal layer DTL3 may include a third connection electrode CE3 and a third sub pad. The third connection electrode CE3 may be connected to the second connection electrode CE2 through a third contact hole CT3 penetrating the second insulating film 181 and the second planarization film 180. The third data metal layer DTL3 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A third planarization film 190 may be disposed on the third data metal layer DTL3. The third planarization film 190 may be formed of an organic film, such as an acrylic resin, an epoxy resin, a phenolic resin, a polyamide resin, a polyimide resin, or the like.

A fourth data metal layer DTL4 may be disposed on the third planarization film 190. The fourth data metal layer DTL4 may include an anode pad electrode APD, a cathode pad electrode CPD, and a fourth sub pad. The anode pad electrode APD may be connected to a third connection electrode CE3 through a fourth contact hole CT4 penetrating the third insulating film 191 and the third planarization film 190. The cathode pad electrode CPD may be supplied with a first power supply voltage that is a low potential voltage. The fourth data metal layer DTL4 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The light emitting element LE is exemplified as a flip-chip type micro LED in which the first contact electrode CTE1 and the second contact electrode CTE2 are disposed to face the anode pad electrode APD and the cathode pad electrode CPD but is not limited thereto. The light emitting element LE may be an inorganic light emitting element made of an inorganic material such as GaN. The light emitting element LE may have a length in the first direction DR1, a length in the second direction DR2, and a length in the third direction DR3 of several to several hundred µm, respectively. For example, the light emitting element LE may have a length in the first direction DR1, a length in the second direction DR2, and a length in the third direction DR3 of approximately 100 µm or less, respectively.

The light emitting elements LE may be grown and formed on a semiconductor substrate such as a silicon wafer. Each of the light emitting elements LE may be transferred directly from the silicon wafer onto the anode pad electrode APD and the cathode pad electrode CPD of the substrate SUB. In this case, the first contact electrode CTE1 and the anode pad electrode APD may be bonded to each other through a bonding process. Further, the second contact electrode CTE2 and the cathode pad electrode CPD may be bonded to each other through the bonding process. The first contact electrode CTE1 and the anode pad electrode APD may be electrically connected to each other through a bonding electrode 23. Furthermore, the second contact electrode CTE2 and the cathode pad electrode CPD may be electrically connected to each other through the bonding electrode 23.

In one example, the bonding electrode 23 may be disposed on one side of the light emitting element LE. The bonding electrode 23 may be a bonding product of pressurized melting bonding using a laser. Here, the pressurized melting bonding refers to a state in which the bonding electrode 23 is heated and melted, and the light emitting element LE, the anode pad electrode APD, and the cathode pad electrode CPD are melted and mixed, and then cooled and solidified when the laser supply is terminated. Since the conductivity of the light emitting element LE, the anode pad electrode APD, and the cathode pad electrode CPD is maintained while being cooled and solidified in a melted and mixed state, the anode pad electrode APD, the cathode pad electrode CPD, and the light emitting element LE may be electrically connected and physically connected, respectively. Accordingly, the bonding electrode 23 may be disposed on the first contact electrode CTE1 and the second contact electrode CTE2 of the light emitting element LE.

The bonding electrode 23 may include, for example, Au, AuSn, PdIn, InSn, NiSn, Au-Au, AgIn, AgSn, Al, Ag, or carbon nanotubes CNT. Each of these may be used alone or in combination of two or more.

Each of the light emitting elements LE may be a light emitting structure including a base substrate SPUB, an n-type semiconductor NSEM, an active layer MQW, a p-type semiconductor PSEM, a first contact electrode CTE1, and a second contact electrode CTE2.

The base substrate SPUB may be a sapphire substrate, but the embodiments of the present disclosure are not limited thereto.

The n-type semiconductor NSEM may be disposed on one surface of the base substrate SPUB. For example, the n-type semiconductor NSEM may be disposed on a bottom surface of the base substrate SPUB. The n-type semiconductor NSEM may be made of GaN doped with n-type conductive dopants such as Si, Ge, Sn, and the like.

The active layer MQW may be disposed on a portion of one surface of the n-type semiconductor NSEM. The active layer MQW may include a material having a single or multiple quantum well structure. When the active layer MQW includes a material having a multi-quantum well structure, it may have a structure in which multiple well layers and barrier layers are alternately laminated. In this case, the well layers may be formed of InGaN, and the barrier layers may be formed of GaN or AlGaN but are not limited thereto. Alternatively, the active layer MQW may have a structure in which semiconductor materials having a large band gap energy and semiconductor materials having a small band gap energy are alternately laminated and may include different group III to group V semiconductor materials depending on the wavelength of the light emitted.

In one embodiment of the present disclosure, a flip-chip type light emitting element has been described as an example, but it is not limited thereto and a vertical type light emitting element may be used.

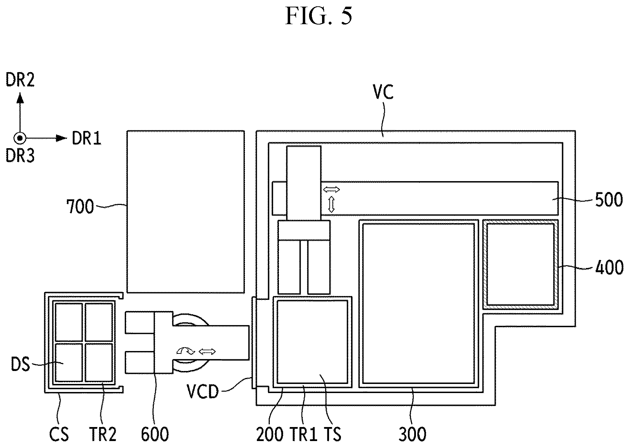

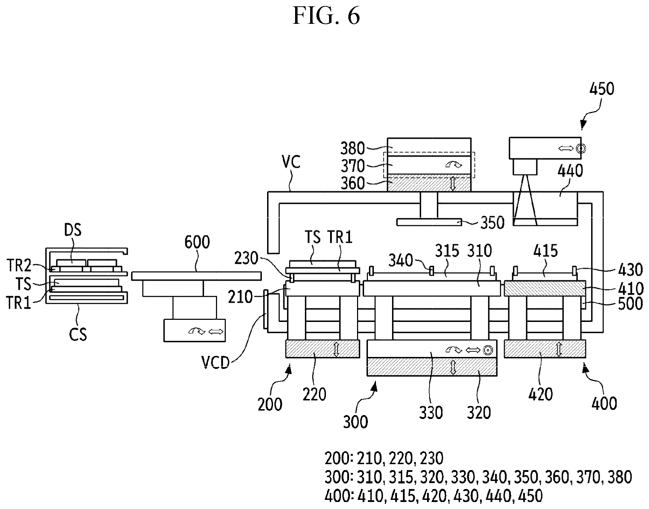

FIG. 5 is a schematic plan view of a light emitting element transfer system according to one embodiment. FIG. 6 is a schematic side view of a light emitting element transfer system according to one embodiment.

Referring to FIGS. 5 and 6, a light emitting element transfer system according to one embodiment may align a first substrate TS and a second substrate DS on which light emitting elements are disposed and bond the light emitting elements to the second substrate DS.

The first substrate TS described herein is a substrate of a light emitting element transfer system, which is a substrate on which a light emitting element is to be transferred. The first substrate TS in the following description will be mainly described as a substrate of an inorganic light emitting display device, as shown in FIG. 4.

The second substrate DS is a substrate of the light emitting element transfer system, which is a substrate on which the light emitting element is disposed and which provides the light emitting element to the first substrate TS.

Specifically, the light emitting element transfer system includes a vacuum chamber VC, a loading portion 200, an alignment portion 300, a bonding portion 400, and a first transfer portion 500, and may further include a second transfer portion 600, a separation portion 700, and a cassette CS. In addition, the light emitting element transfer system may further include a controller that controls each component. The controller may be connected to each component, for example, the loading portion 200, the alignment portion 300, the bonding portion 400, and the first transfer portion 500, and the second transfer portion 600, and may control the operation of each component.

The vacuum chamber VC provides an internal process space where manufacturing processes such as alignment, lamination, bonding, laser irradiation, and movement are performed. The vacuum chamber VC provides a process space for vacuum, heating, soundproofing, cooling, vibration-free, and waterproofing, etc., and may further include a vacuum device, an air suction device, a purification device, a heating device, a cooling device, and the like.

For example, the vacuum chamber VC may be maintained in a vacuum state by a vacuum device including a vacuum pump and a vacuum valve. For example, the vacuum chamber VC may include a gate valve and a door VCD. The gate valve and the door VCD may be disposed on one side of the vacuum chamber VC. The gate valve may be disposed on one side of the vacuum chamber VC. The first substrate TS and the second substrate DS may be supplied into the vacuum chamber VC through the gate valve. That is, the gate valve may provide a path through which the first substrate TS and the second substrate DS may enter and exit. The second substrate DS may be smaller than the first substrate TS. For example, the sum of the areas of four second substrates DS may be equal to the area of one first substrate TS.

A loading portion 200, an alignment portion 300, a bonding portion 400, and a first transfer portion 500 may be disposed inside the vacuum chamber VC. Some of the loading portion 200, the alignment portion 300, and the bonding portion 400 may be disposed outside the vacuum chamber VC, but the loading process, the alignment process, and the bonding process are performed in the same vacuum atmosphere within one vacuum chamber VC. Therefore, problems such as air being trapped between the first substrate TS and the second substrate DS during the alignment process and the bonding process, thereby reducing the alignment degree or interfering with the transmission of the pressurization force, do not occur.

The loading portion 200 is provided on one side of the process space inside the vacuum chamber VC. For example, the loading portion 200 may be disposed adjacent to the door VCD of the vacuum chamber VC, and the alignment portion 300 and bonding portion 400 may be disposed side by side next to the loading portion 200. The loading portion loads trays TR1 and TR2 or first substrates TS. For example, trays TR1 and TR2 brought in from outside the vacuum chamber VC through the door VDC are seated on the loading portion 200.

The loading portion 200 may include a stage 210, a lifting member 220, and a protrusion member 230.

The stage 210 may transport and seat trays TR1 and TR2 or a first substrate TS from the outside, but in one embodiment, the trays TR1 and TR2 are seated as an example. The trays TR1 and TR2 may include a first tray TR1 on which a first substrate TS is seated and a second tray TR2 on which a second substrate DS is seated. The stage 210 has a wider surface than the first substrate TS.

The lifting member 220 may be disposed on the side or bottom of the stage 210 to raise and lower the stage 210. The lifting member 220 may include a lifting cylinder or the like.

The protrusion member 230 may protrude above the top surface of the stage 210. For example, one or more protrusion members 230 may be disposed around the stage 210 in a pin shape. When the protrusion member 230 protrudes toward the top surface of the stage 210, the trays TR1 and TR2 disposed on the top surface of the stage 210 may be separated from the top surface of the stage 210, and at least a portion of the back surface (bottom surface) of the trays TR1 and TR2 may be in a floating state (a state in the air). In this way, the trays TR1 and TR2 in the floating state become easily lifted by the first transfer portion 500 later.

In the case where the protrusion member 230 is configured to not move up and down, the stage 210 may be lifted to the upper portion or higher of the protrusion member, thereby bringing the stage 210 and the top surface of the trays TR1 and TR2 into contact.

In another modified example, the protrusion member 230 may be formed to be protruded or concealed within a groove defined in the top surface of the stage 210 when not used.

The first transfer portion 500 is provided to be able to move along a predetermined path through a rail or the like disposed inside the vacuum chamber VC, thereby transferring the trays TR1 and TR2 from the loading portion 200 to the alignment portion 300 and from the alignment portion 300 to the bonding portion 400. For example, the first transfer portion 500 may be a vacuum robot but is not limited thereto. The vacuum robot is a transfer robot used in a vacuum environment, and may stably transfer substrates and trays, etc., including a multi-joint arm and fingers.

Meanwhile, in the bonding state of the first substrate TS and the second substrate DS, the alignment of the first substrate TS and the second substrate DS may be misaligned even by a small impact. Therefore, transporting the bonded first substrate TS and the second substrate DS in the tray state to the bonding device may be more advantageous in that it may reduce the possibility of the alignment of the first substrate TS and the second substrate DS.

The alignment portion 300 may be disposed adjacent to the loading portion 200 inside the vacuum chamber VC.

The first transfer portion 500 may transfer the first tray TR1 with the first substrate TS disposed thereon, if the first substrate TS is disposed on the first tray TR1.

In addition, the first transfer portion 500 may transfer the first substrate TS and the second substrate TS in the aligned and bonded state from the alignment portion 300 to the bonding portion 400. Furthermore, the first transfer portion 500 may transfer the first substrate TS and the second substrate TS, on which the bonding of the light emitting element is completed in the bonding portion 400, back to the loading portion 200.

The alignment portion 300 may align and bond the first substrate TS and the second substrate DS disposed in the loading portion 200. For this purpose, the first substrate TS and the second substrate DS may include alignment marks. Furthermore, the alignment portion 300 may include a stage 310, a first lifting member 320, a first driving member 330, a protrusion member 340, a holding member 350, a second lifting member 360, a second driving member 370, and a vision member 380.

The stage 310, the protrusion member 340, the first lifting member 320, and the first driving member 330 may be collectively referred to as a "stage module" of the alignment portion 300.

The stage module may be a high-precision stage, also called a UVW stage, as an alignment stage. The stage module has high precision for position alignment. The stage module has a two-layer structure including the first lifting member 320 and the first driving member 330 for driving. The UVW stage controls the rotation direction at both ends of the stage, thereby enabling high-precision positioning. However, the UVW stage cannot withstand high pressure force compared to a general stage. Therefore, the bonding process, which applies high pressure, is not performed on the UVW stage, but is performed on a separate stage (heating stage) 410.

The stage 310 is configured to support the first tray TR1 on which the first substrate TS or the first substrate TS is disposed during the alignment process. The stage 310 may have a larger area than the stage 210 of the loading portion 200. For example, the stage 310 may be sized to allow four first substrates TS to be disposed without overlapping at the same time but is not limited thereto.

A plurality of holding mechanisms 315, such as electrostatic chucks, may be disposed on the top surface of the stage 310 to hold the first tray TR1 so that it does not move during the alignment process.

The stage 310 may be referred to as the alignment stage 310 to clearly distinguish it from the stage 210 of the loading portion 200.

The first lifting member 320 may be disposed below the stage 310 to raise and lower the stage 310. The lifting member 220 may include a lifting cylinder, etc.

The first driving member 330 is disposed between the first lifting member 320 and the stage 310 and may precisely move the stage 310 in the first direction DR1 and the second direction DR2 or rotate the stage 310 around an axis parallel to the third direction DR3 during the alignment process.

The protrusion member 340 may protrude and be hidden from the top surface of the stage 310 when not used. For example, the protrusion member 340 is disposed in a groove formed on the top surface of the stage 310 and may protrude above the top surface of the stage 310. When the protrusion member 340 protrudes, the first tray TR1 or the first substrate TS disposed on the top surface of the protrusion member 340 may be raised and lowered in a vertical direction (third direction). For example, one or more protrusion members 340 may be disposed around the perimeter of the stage 310 in a pin shape. When the protrusion member 340 protrudes toward the top surface of the stage 310, the first tray TR1 disposed on the top surface of the stage 310 may be separated from the top surface of the stage 310 so that at least a portion of the back surface of the first tray TR1 may be in a floating state (a state in the air). In this way, the trays TR1 and TR2 in the floating state become easily lifted by the first transfer portion 500 later.

The holding member 350 is disposed on the ceiling of the vacuum chamber VC but overlaps the stage 310. The holding member 350 adsorbs or grips the back surface (upper surface in FIG. 6) of the second substrate DS to support the second substrate DS above the first substrate TS during the alignment process. The holding member 350 may include a holding mechanism 315 such as a vacuum absorption method, a mechanical chuck, or an electrostatic chuck. For example, the holding member 350 may be an electrostatic chuck but is not limited thereto.

The second lifting member 360 is disposed on top of the holding member 350 to raise and lower the holding member 350 in the third direction DR3. The second lifting member 360 may include an elevating cylinder, etc.

The second driving member 370 is disposed on top of the second lifting member 360 to move the holding member 350 in the first direction DR1 and the second direction DR2 or rotate the holding member 350 around an axis parallel to the third direction DR3.

The vision member 380 recognizes alignment markers disposed on the first substrate TS and the second substrate DS. For example, the vision member 380 may include at least one camera module. The vision member 380, the second lifting member 360, and the second driving member 370 are illustrated as being disposed outside the vacuum chamber VC but are not limited thereto. For example, the vision member 380 may be disposed inside the vacuum chamber VC.

The bonding portion 400 may apply heat and pressure to the first substrate TS and the second substrate DS that have been moved in a bonded state by the first transfer portion 500 and may irradiate a laser to transfer the light emitting elements disposed on the second substrate DS to the first substrate TS.

The bonding portion 400 may include a heating stage 410, a lifting member 420, a protrusion member 430, a pressure member 440, and a laser member 450.

The heating stage 410 may be equipped with a built-in heater. The heater is configured to generate heat, for example, by using an electric heater. The heater conducts heat through the stages 310 to heat the first substrate TS supported on the heating stage 410. The temperature of the first substrate TS or its bonding surface may be controlled by controlling the amount of heat generated by the heater.

A holding mechanism 415, such as an electrostatic chuck, may be disposed on the top surface of the heating stage 410 to hold the first substrate TS so that it does not move during the bonding process.

The lifting member 420 may be disposed on the side or lower side of the heating stage 410 to raise and lower the heating stage 410. The lifting member 420 may include an elevating cylinder, etc.

The protrusion member 430 may be disposed in a groove formed on the top surface of the heating stage 410 and may protrude above the top surface of the heating stage 410. When the protrusion member 430 protrudes, the first tray TR1 disposed on the upper portion of the protrusion member 430 may be raised and lowered in the vertical direction (third direction). For example, the protrusion member 430 may be disposed in a pin shape and one or more may be disposed around the first tray TR1. When the protrusion member 430 protrudes toward the top surface of the heating stage 410, the first tray TR1 disposed on the top surface of the heating stage 410 may be separated from the top surface of the heating stage 410 so that at least a portion of the back surface of the first tray TR1 may be in a floating state (a state in the air). In this way, the first tray TR1 in the floating state may be easily lifted by the first transfer portion 500 later.

The heating stage 410, the lifting member 420, and the protrusion member 430 may be collectively referred to as a "stage module" of the bonding portion 400. To distinguish them from the stage modules of the alignment portion 300, they may be referred to as "bonding stage modules".

The bonding stage module may withstand a higher pressure than the stage module of the alignment portion 300.

The pressure member 440 is disposed on the ceiling of the vacuum chamber VC and overlaps the heating stage 410. The pressure member 440 may pressurize the first substrate TS and the second substrate DS sequentially disposed on the first tray TR1.

At least a portion of the pressure member 440 may be made of a transparent material. Accordingly, light emitted from the laser member 450 may penetrate the transparent material of the pressure member 440.

Preferably, a glass or ceramic material is used as the transparent material. The transparent material need not be transparent to the naked eye but need only consist of a material through which the light emitted by the light source is transmitted.

The laser member 450 may include a driving system that movable in the first direction DR1 and the second direction DR2 on one side. The laser member 450 is disposed on top of the pressure member 440 and may irradiate laser light to the first substrate TS and the second substrate DS.

The laser member 450 may be configured in various forms, such as a form that continuously irradiates a specific area or a form that scans.

The vacuum chamber VC may break the vacuum atmosphere when the bonding process is completed.

The second transfer portion 600 may disposed outside the vacuum chamber VC and may load the first tray TR1 or the second tray TR2 loaded in the cassette CS into the vacuum chamber VC or unload the first tray TR1 or the second tray TR2 within the vacuum chamber VC. The unloaded first tray TR1 and second tray TR2 may be disposed in the separation portion 700. The second transfer portion 600 may comprise a robotic arm or the like capable of transferring the trays TR or substrates TS and DS.

The separation portion 700 may separate and load the first tray TR1 and the first substrate TS disposed on the first tray TR1. Also, the second tray TR2 and the second substrate DS may also be separated and loaded.

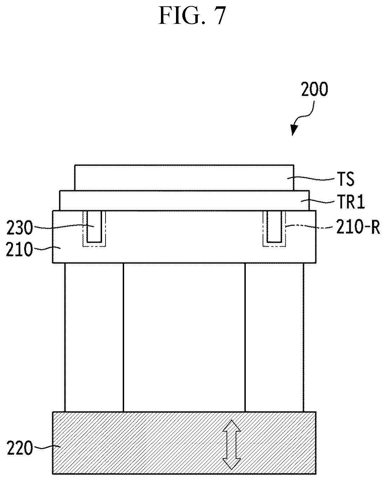

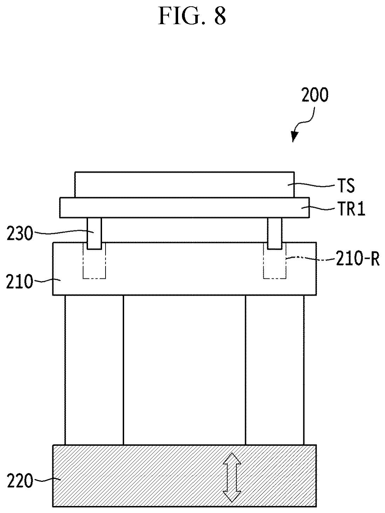

FIGS. 7 and 8 are enlarged views of the loading portion according to the embodiment of FIGS. 5 and 6. FIGS. 7 and 8 are side views to illustrate the movement of the protrusion member 230 of the loading portion 200. FIG. 7 illustrates a state in which the protrusion member 230 is inserted into the groove 210-R of the stage 210, and FIG. 8 illustrates a state in which the protrusion member 230 is protruded from the stage 210.

Referring to FIG. 7, a first tray TR1 is loaded onto the stage 210 of the loading portion 200. A first substrate TS is disposed on the first tray TR1.

The protrusion member 230 of the loading portion 200 is disposed within the groove 210-R of the stage 210. Therefore, the top surface of the stage 210 may be flat.

The first tray TR1 is disposed on the top surface of the stage 210 without lifting.

Referring to FIG. 8, the protrusion member 230 of the loading portion 200 may protrude outward to lift the first tray TR1. The first tray TR1 may be separated from the top surface of the stage 210 and be in a floating state. The arm of the first transfer portion 500 may be inserted into the space between the first tray TR1 and the stage 210 to lift the first tray TR1.

According to one embodiment, the alignment process and the bonding process may be performed in the same vacuum atmosphere of one vacuum chamber, but the alignment process stage and the bonding process stage can be different from each other, so that the bonding process may be completed without misalignment of the first substrate and the second substrate.

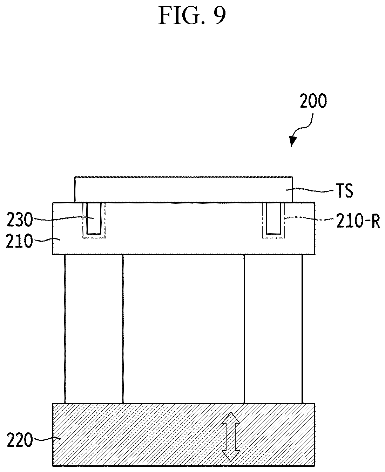

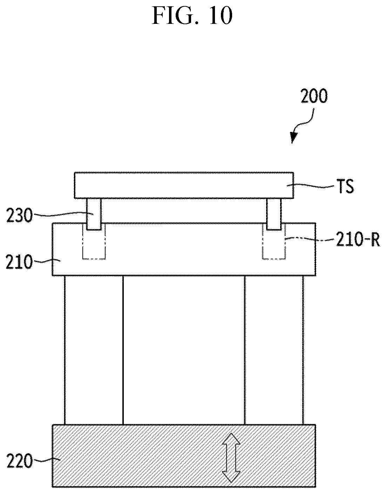

FIGS. 9 and 10 are enlarged views of the loading portion according to another embodiment of FIGS. 7 and 8.

The embodiments of FIGS. 9 and 10 differ from the embodiments of FIGS. 7 and 8 in that the first substrate TS is transported without a tray. In FIGS. 9 and 10, descriptions that overlap with the embodiments of FIGS. 7 and 8 will be omitted, and differences from the embodiments of FIGS. 7 and 8 will be mainly described.

Referring to FIGS. 9 and 10, the first substrate TS is disposed in the cassette CS without a tray. The first substrate TS is introduced into the loading portion 200 in the vacuum chamber VC by the second transfer portion 600 and is settled. The first substrate TS is disposed in the alignment portion 300 and the bonding portion 400 without a tray, and the process is performed.

The loading portion 200 has a protrusion member 230 that pushes the first substrate TS up from the stage 210 to make it a floating state. The first substrate TS may be separated from the top surface of the stage 210 and be in a floating state. The arm of the first transfer portion 500 may be inserted into the space between the first substrate TS and the stage 210 to lift the first substrate TS. The first transfer portion 500 transfers the first substrate TS from the loading portion 200 to the alignment portion 300.

According to one embodiment, since the alignment process and the bonding process may be continuously performed in a high vacuum environment without opening the vacuum chamber within one vacuum chamber VC, the production efficiency of the transfer device may be increased.

Since the alignment process and the bonding process may be performed in a high vacuum environment, the penetration of moisture or oxygen into the light emitting element of the target substrate may be minimized. Therefore, the reliability of the element of the target substrate, i.e., the display device, may be improved.

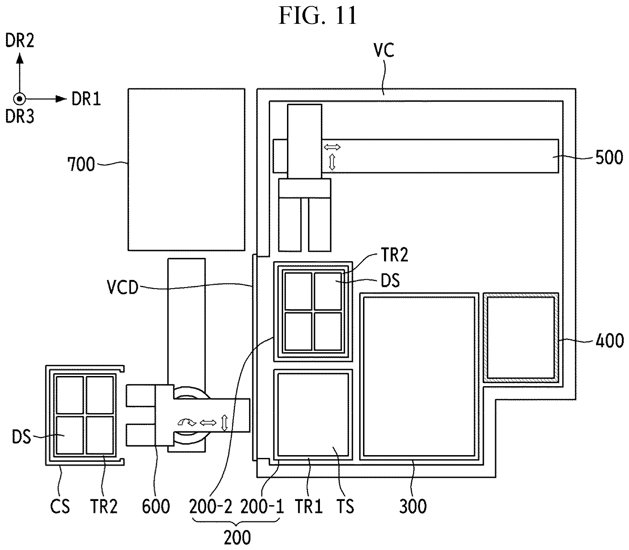

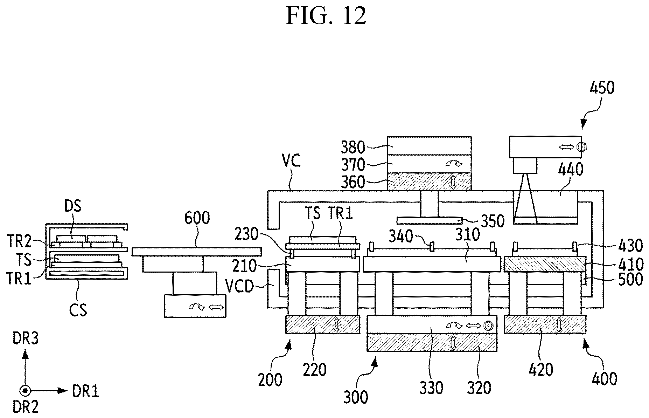

FIG. 11 is a schematic plan view illustrating a light emitting element transfer system according to another embodiment. FIG. 12 is a side view of the light emitting element transfer system of FIG. 11.

The embodiment of FIGS. 11 and 12 is different from FIGS. 5 and 6 in that the loading portion 200 includes a first loading portion 200-1 and a second loading portion 200-2. In FIGS. 11 and 12, descriptions that overlap with the embodiment of FIGS. 5 and 6 will be omitted, and differences from the embodiment of FIG. 5 will be mainly described.

Referring to FIGS. 11 and 12, the first loading portion 200-1 and the second loading portion 200-2 are disposed adjacent to a door VCD of the vacuum chamber VC, and the width of the door VCD may be greater than or equal to the width of the first loading portion 200-1 and the second loading portion 200-2.

The first loading portion 200-1 loads a first tray TR1 and the second loading portion 200-2 loads a second tray TR2. For example, the second transfer portion 600 may transfer the first tray TR1 from the cassette CS to the first loading portion 200-1. Also, the second transfer portion 600 may transfer the second tray TR2 from the cassette CS to the second loading portion 200-2.

The alignment portion 300 and the bonding portion 400 may be disposed side by side next to the loading portion 200. The loading portion 200 is loaded with trays TR1 and TR2 or first substrates TS. For example, the trays TR1 and TR2 brought in through the door VDC from outside the vacuum chamber VC are loaded into the loading portion 200.

The first transfer portion 500 transfers the first tray TR1 on which the first substrate TS is disposed from the first loading portion 200-1 to the alignment portion 300 and transfers the second substrate DS on which the second substrate TS is disposed from the second loading portion 200-2 to the alignment portion 300. For example, the first transfer portion 500 places the first tray TR1 from the first loading portion 200-1 on the stage 310 of the alignment portion 300, and the first lifting member 320 lifts and lowers the first tray TR1 until it is disposed on the stage 310.

In another embodiment, the first substrate TS may be loaded onto the cassette CS without a tray. In this case, the second transfer portion 600 can load the first substrate TS onto the first loading portion 200-1. The movement width of the second transfer portion 600 may also be the same as the width of the door VCD. Compared to the embodiment of FIG. 5, the movement width of the second transfer portion 600 in FIG. 11 has increased further.

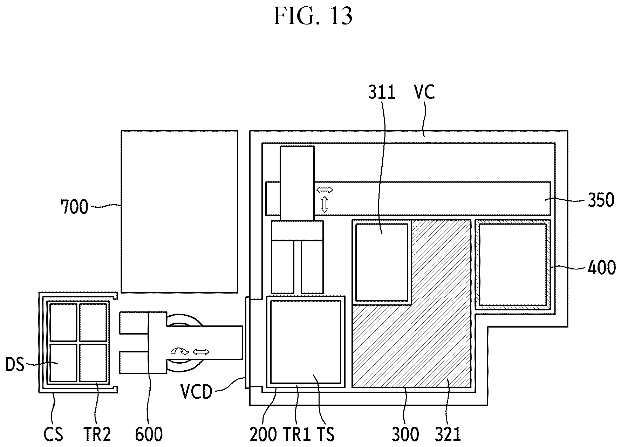

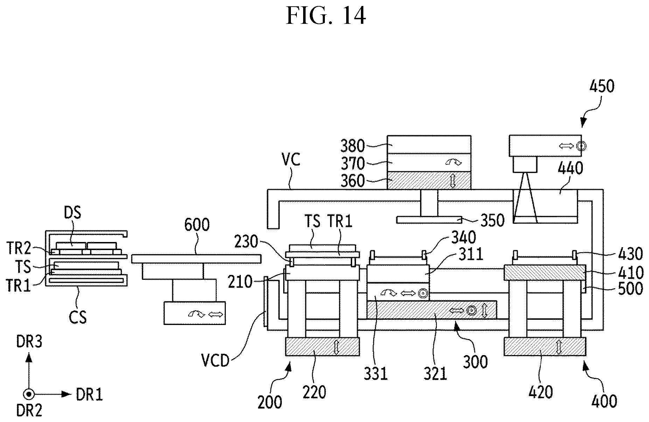

FIG. 13 is a schematic plan view of a light emitting element transfer system according to another embodiment. FIG. 14 is a side view of the light emitting element transfer system of FIG. 13.

FIGS. 13 and 14 are different from the embodiments of FIGS. 5 and 6 in that the stage 311 and the first driving member 331 of the alignment portion 300 each have a smaller area than a first lifting member 321, the first driving member 331 may move in the first direction DR1 and the second direction DR2 on the major surface plane of the first lifting member 321, and the first lifting member 321 may move left and right (i.e., the first direction DR1) as well as vertically (i.e., the third direction DR3). In FIGS. 13 and 14, descriptions that overlap with the embodiments of FIGS. 5 and 6 will be omitted, and differences from the embodiments of FIGS. 5 and 6 will be mainly described.

The stage 311, the first lifting member 321, and the first driving member 331 may be collectively referred to as a stage module.

The stage module may be a high-precision stage, also called a UVW stage, as an alignment stage.

The stage 311 is preferably of a size in which one first substrate TS may be disposed.

A plurality of holding mechanisms 315, for example, electrostatic chucks, may be disposed on the top surface of the stage 311 to hold the first tray TR1 so that it does not move during the alignment process.

The first lifting member 321 may be disposed below the stage 311 and may raise and lower the stage 311 in the third direction DR3. Furthermore, the first lifting member 321 may move the stage 311 and the first driving member 331 in the first direction DR1 and the second direction DR2. Therefore, the first lifting member 321 may move the stage 311 portion 500not only vertically but also in the first direction DR1 and the second direction DR2 on the top surface of the first lifting member 321 without the help of the first transfer portion 500. For example, the first lifting member 321 may move the stage 311 in the first direction DR1 and the second direction DR2 to move the first tray TR1 to an alignment position with the next second substrate DS. The first direction DR1 may be referred to as an "arrangement direction".

The lifting member 220 may include a lifting cylinder or the like.

In another embodiment, the first substrate TS is disposed in the cassette CS without a tray. The first substrate TS is introduced into the loading portion 200 in the vacuum chamber VC by the second transfer portion 600 and is settled. The first substrate TS is disposed in the alignment portion 300 and the bonding portion 400 without a tray, and the process is performed.

The loading portion 200 has a protrusion member 230 that pushes the first substrate TS up from the stage 210 to make it a floating state. The first substrate TS may be in a floating state separated from the top surface of the stage 210. An arm of the first transfer portion 500 may be inserted into the space between the first substrate TS and the stage 210 to lift the first substrate TS. The first transfer portion 500 transfers the first substrate TS from the loading portion 200 to the alignment portion 300.

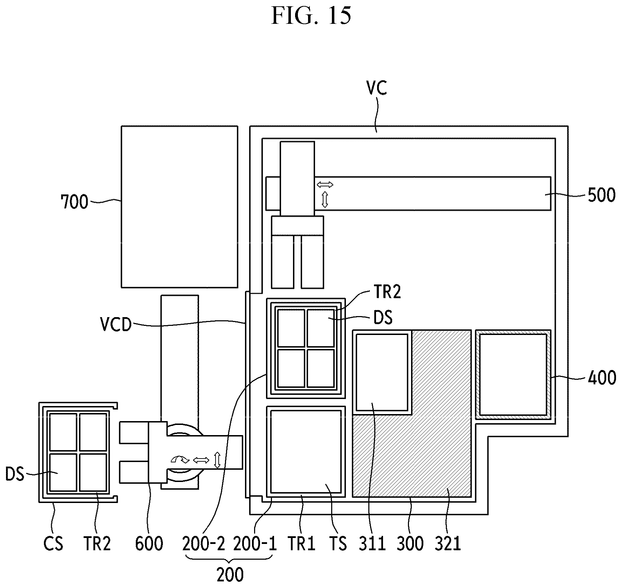

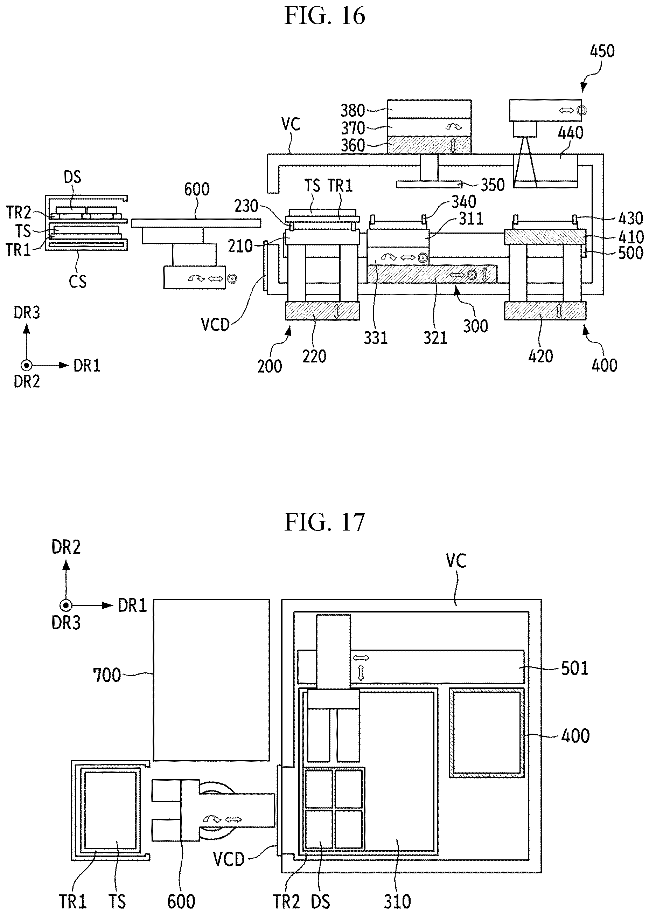

FIG. 15 is a schematic plan view illustrating a light emitting element transfer system according to another embodiment. FIG. 16 is a side view of the light emitting element transfer system of FIG. 15.

FIG. 15 and FIG. 16 are different from the embodiment of FIG. 13 and FIG. 14 in that the loading portion 200 includes a first loading portion 200-1 and a second loading portion 200-2. In FIG. 15 and FIG. 16, descriptions that overlap with the embodiment of FIG. 13 and FIG. 14 will be omitted, and differences from the embodiment of FIG. 13 and FIG. 14 will be mainly described.

Referring to FIG. 15 and FIG. 16, the first loading portion 200-1 and the second loading portion 200-2 are disposed adjacent to a door VCD of the vacuum chamber VC, and the width of the door VCD may be greater than or equal to the width of the first loading portion 200-1 and the second loading portion 200-2.

The first loading portion 200-1 loads a first tray TR1 and the second loading portion 200-2 loads a second tray TR2. For example, the second transfer portion 600 may transfer a first tray TR1 from the cassette CS to the first loading portion 200-1. Additionally, the second transfer portion 600 may transfer a second tray TR2 from the cassette CS to the second loading portion 200-2.

The alignment portion 300 and the bonding portion 400 may be disposed side by side next to the loading portion 200. The loading portion 200 is loaded with trays TR1 and TR2 or first substrates TS. For example, trays TR1 and TR2 brought in through the door VDC from outside the vacuum chamber VC are loaded into the loading portion 200.

The first transfer portion 500 transfers the first tray TR1 on which the first substrate TS is disposed from the first loading portion 200-1 to the alignment portion 300 and transfers the second substrate DS on which the second substrate TS is disposed from the second loading portion 200-2 to the alignment portion 300. For example, the first transfer portion 500 places the first tray TR1 from the first loading portion 200-1 on the stage 311 of the alignment portion 300, and the first lifting member 320 lifts and lowers the first tray TR1 until it is disposed on the stage 311.

In another embodiment, the first substrate TS may be loaded onto the cassette CS without a tray. In this case, the second transfer portion 600 may load the first substrate TS into the first loading portion 200-1. The movement width of the second transfer portion 600 may also be the same as the width of the door VCD. Compared to the embodiment of FIG. 13, the movement width of the second transfer portion 600 in FIG. 15 has increased further.

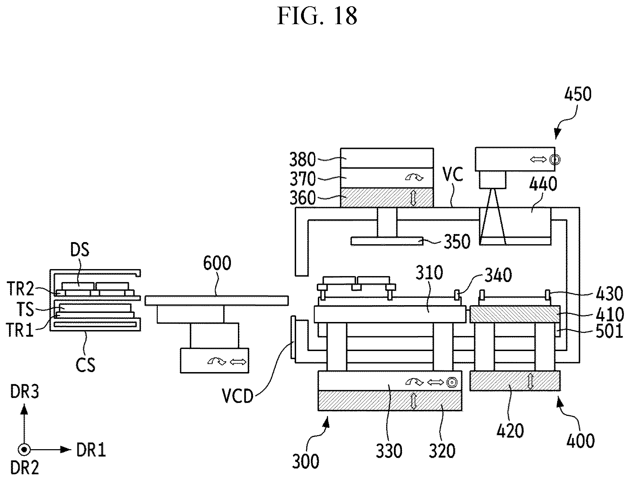

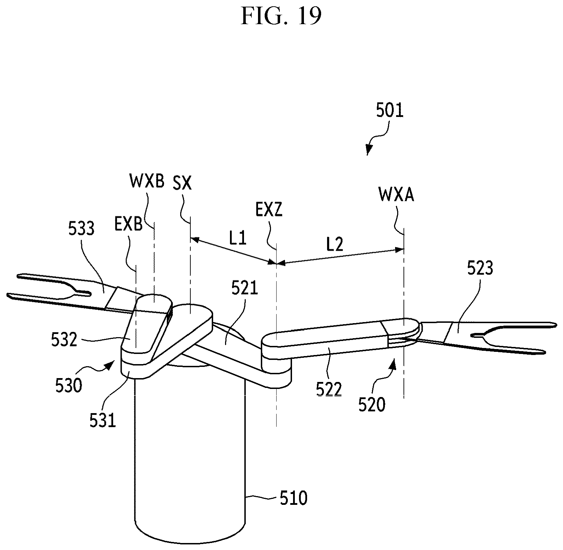

FIG. 17 is a schematic plan view illustrating a light emitting element transfer system according to another embodiment. FIG. 18 is a side view of the light emitting element transfer system of FIG. 17. FIG. 19 is a perspective view to illustrate the configuration of the first transfer portion.

The embodiment of FIGS. 17 and 18 is different from FIGS. 5 and 6 in that the light emitting element transfer system does not include a loading portion 200 and the first transfer portion 501 is dual-armed. In FIGS. 11 and 12, descriptions that overlap with the embodiment of FIGS. 5 and 6 will be omitted, and differences from the embodiment of FIG. 5 will be mainly described.

Referring to FIGS. 17 and 18, a light emitting element transfer system may include a vacuum chamber VC, an alignment portion 300, a bonding portion 400, and a first transfer portion 501 and may further include a second transfer portion 600, a separation portion 700, and a cassette CS. Also, the light emitting element transfer system may further include a controller that controls each component. The controller is connected to each component, for example, the alignment portion 300, the bonding portion 400, the first transfer portion 501, and the second transfer portion 600 and may control the operation of each component.

The second transfer portion 600 transfers the first tray TR1 or the second tray TR2 from the cassette CS to the alignment portion 300.

Since there is no separate loading portion 200, the first transfer portion 501 may transfer or hold the first tray TR1 and the second tray TR2 using a dual arm and stand by. For example, a plurality of second substrates DS are aligned on the second tray TR2, and while one of the plurality of second substrates DS included in the second tray TR2 is aligned and bonded onto the first substrate, the first arm may support the second tray TR2.

The vacuum chamber VC may include a door VCD. The width of the door VCD corresponds to the width of the trays TR1 and TR2 so that the trays TR1 and TR2 may be entered and exited. Here, the meaning of corresponding is similar to the width of the trays TR1 and TR2 but may include additional margin.

Referring to FIG. 19, the first transfer portion 501 may be a vacuum robot having a dual arm.

The first transfer portion 501 may have a driving section 510 and one or more arms 520 and 530. The arms 520 and 530 may be attached to the driving section 510, which may have, for example, a three-axis or four-axis driving system as described later. The arms 520 and 530 are illustrated in the drawings as, for example, three-link arms and may be co-axially coupled to the driving section 510 and may be stacked vertically on top of each other to allow independent theta motion (e.g., using a four-axis drive) or coupled theta motion (e.g., using a three-axis drive). Here, the combined theta motion is the rotation of the robot arm as a unit about the shoulder axis SX without substantially extending or retracting. Each arm is driven by a pair of motors and may have any suitable drive pulley configuration. For example, the ratio between the shoulder pulley, elbow pulley and wrist pulley for each arm may be, for non-limiting purposes, a 1:1:2 ratio or a 2:1:2 ratio. For example, to extend each arm using a 1:1:2 ratio, each motor in a pair of motors is rotated in substantially equal and opposite directions. For example, to extend each arm using a 2:1:2 ratio, the shoulder pulley is substantially fixed (e.g., substantially not rotating) and the motor coupled to the upper arm is rotated to extend the arm. Theta motion is controlled by rotating the motors in the same direction and at substantially the same speed.

The upper arms 521 and 531 and the forearms 522 and 532 of the individual arms 520 and 530 may be substantially the same length or may be different lengths. For example, the upper arms 521 and 531 may be longer than the forearms 522 and 532, or vice versa. For arm sections of substantially equal length, the distance L1 between each of the elbow axes EXA and EXB and the shoulder axes SX may be substantially equal to the distance L2 between each of the elbow axes EXA and EXB and an individual one of the wrist axes WXA and WXB.

The ends of the forearms 522 and 532 may be provided with end actuators 523 and 533. The end actuators 523 and 533 may be configured in any suitable manner to hold one or more substrates TS and DS or trays TR1 and TR2. For example, while the end actuators 523 and 533 are illustrated as having a single blade for holding a single substrate, it should be appreciated that the end actuators may have multiple blades for holding multiple substrates.

The driving section 510 may receive commands from, for example, a controller, and may manage radial motion, circumferential motion, lifting motion, combined motion, and other motions of the arms 520 and 530 in response thereto.

In another embodiment, the first substrate TS is disposed in the cassette CS without a tray. The first substrate TS is introduced into the loading portion 200 in the vacuum chamber VC by the second transfer portion 600 and is settled. The first substrate TS is disposed in the alignment portion 300 and the bonding portion 400 without a tray, and the process is performed.

The loading portion 200 has a protrusion member 230 that pushes the first substrate TS up from the stage 210 to make it a floating state. The first substrate TS may be in a floating state separated from the top surface of the stage 210. An arm of the first transfer portion 500 may be inserted into the space between the first substrate TS and the stage 210 to lift the first substrate TS. The first transfer portion 500 transfers the first substrate TS from the loading portion 200 to the alignment portion 300.

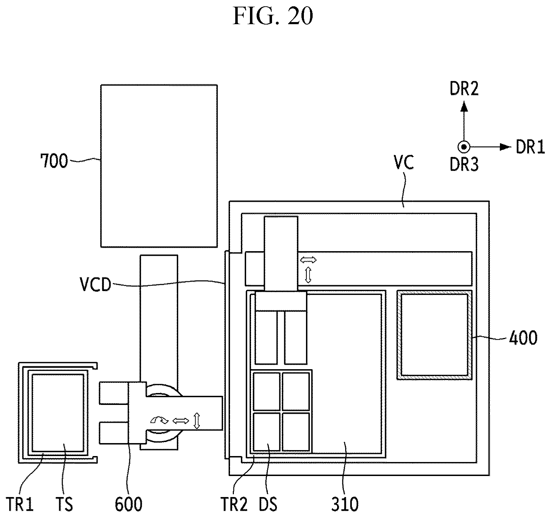

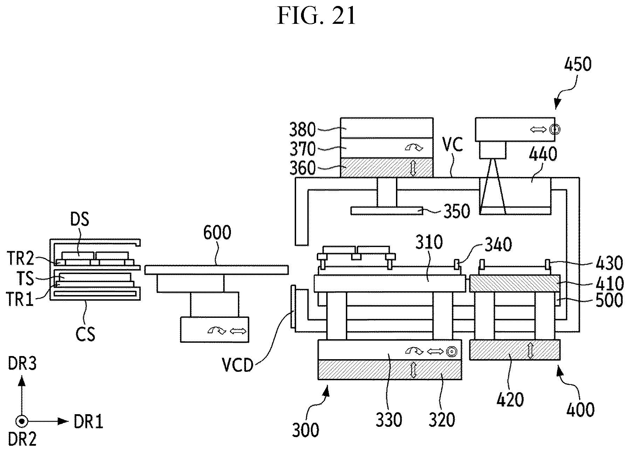

FIG. 20 is a plan view schematically illustrating a light emitting element transfer system according to another embodiment. FIG. 21 is a side view of the light emitting element transfer system of FIG. 20.

The embodiments of FIGS. 20 and 21 differ from FIGS. 17 and 18 in that the width of the door VCD corresponds to the width of the stage 310 in the second direction DR2. In FIGS. 20 and 21, descriptions that overlap with the embodiments of FIGS. 17 and 18 will be omitted, and differences from the embodiments of FIGS. 17 and 18 will be mainly described.

The width of the door VCD may correspond to the width of the stage 310. The moving width of the second transfer portion 600 may also be the same as the width of the door VCD. Accordingly, the second transfer portion 600 may load the first tray TR1 and the second tray TR2 into the stage 310 but may load the first tray TR1 and the second tray TR2 at different locations in the stage 310. For example, the second transfer portion 600 may place the second tray TR1 in the first region first, and the first tray TR1 in the second area. The first area and the second area are adjacent to each other but do not overlap. The second area may be closer to the second transfer portion 501 than the first area.

In another embodiment, the first substrate TS is placed in the cassette CS without a tray. The second transfer portion 600 may place the second tray TR1 in the first area first, and then place the first substrate TS in the second area. The first area and the second area are adjacent to each other but do not overlap. The second area may be closer to the second transfer portion 501 than the first area.

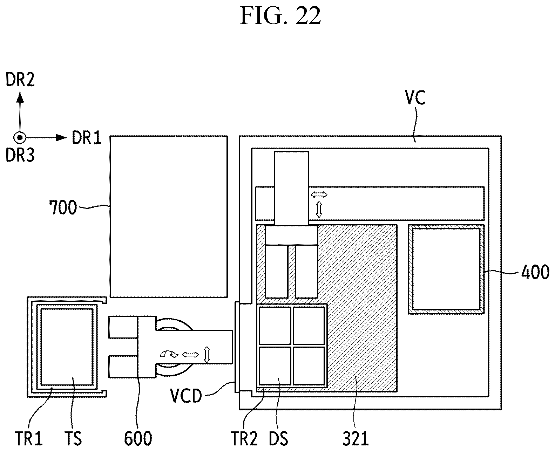

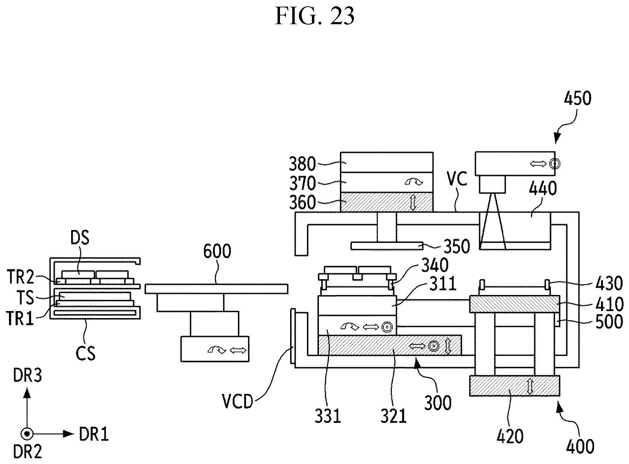

FIG. 22 is a plan view schematically illustrating a light emitting element transfer system according to another embodiment. FIG. 23 is a side view of the light emitting element transfer system of FIG. 22.

The embodiment of FIGS. 22 and 23 is different from FIGS. 17 and 18 in that the stage 311 and the first driving member 331 of the alignment portion 300 have a smaller area than the first lifting member 321, the first driving member 331 may move in the first direction DR1 and the second direction DR2 on the major surface plane of the first lifting member 321, and the first lifting member 321 may move left and right as well as vertically. In FIGS. 22 and 23, descriptions that overlap with the embodiment of FIGS. 17 and 18 will be omitted, and differences from the embodiment of FIGS. 17 and 18 will be mainly described.

The stage 310, the first lifting member 320, and the first driving member 330 may be collectively referred to as a stage module.

The stage module may be a high-precision stage, also called a UVW stage, as an alignment stage.

The stage 311 is preferably of a size in which one first substrate TS may be disposed.

A plurality of holding mechanisms 315, for example, electrostatic chucks, may be disposed on the top surface of the stage 311 to hold the first tray TR1 so that it does not move during the alignment process.

The first lifting member 321 may be disposed below the stage 311 and may raise and lower the stage 311 in the third direction DR3. Furthermore, the first lifting member 321 may move the stage 311 and the first driving member 331 in the first direction DR1 and the second direction DR2. Therefore, the first lifting member 321 may move the stage 311 not only vertically but also in the first direction DR1 and the second direction DR2 on the top surface of the first lifting member 321 without the help of the first transfer portion 500. For example, the first lifting member 321 may move the stage 311 in the first direction DR1 and the second direction DR2portion 500 to move the first tray TR1 to an alignment position with the next second substrate DS.

The lifting member 220 may include a lifting cylinder or the like.

In another embodiment, the first substrate TS is placed in the cassette CS without a tray. The second transfer portion 600 may place the second tray TR1 in the first area first, and then place the first substrate TS in the second area. The first area and the second area are adjacent to each other but do not overlap. The second area may be closer to the second transfer portion 501 than the first area.

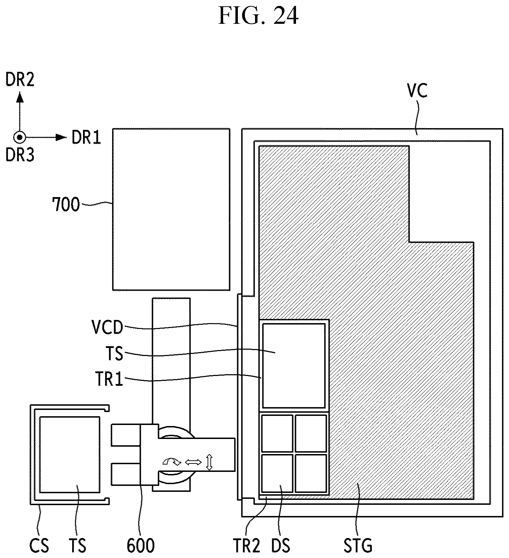

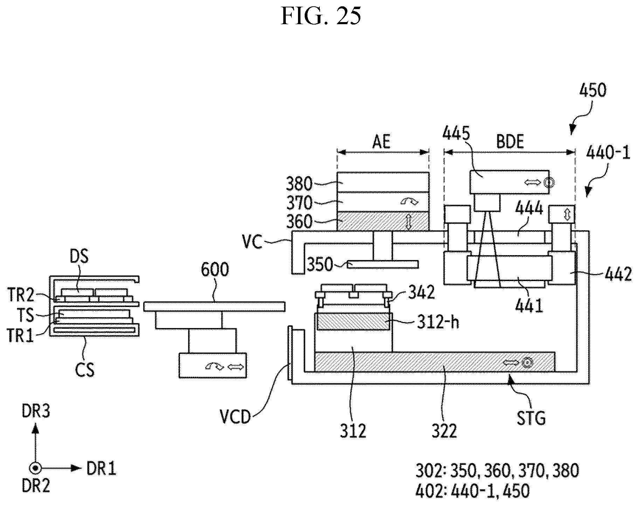

FIG. 24 is a schematic plan view illustrating a light emitting element transfer system according to another embodiment. FIG. 25 is a side view of the light emitting element transfer system of FIG. 24.

The most significant difference between the embodiment of FIGS. 24 and 25 and the embodiment of FIGS. 17 and 18 is that the first transfer portion 501 is not disposed in the vacuum chamber VC in the embodiment of FIGS. 24 and 25. The stage 312 of the alignment area AE is different from the embodiment of FIGS. 17 and 18 in that stage 312 has a heater and functions as a stage of the bonding area BDE, and the width of the door VCD corresponds to the width of the stage 310. In FIGS. 24 and 25, descriptions that overlap with the embodiment of FIGS. 17 and 18 will be omitted, and differences from the embodiment of FIGS. 17 and 18 will be mainly described.

Referring to FIGS. 24 and 25, a light emitting element transfer system includes a vacuum chamber VC, a stage module STG, an alignment portion 302, and a bonding portion 402, and may further include a transfer portion 600, a separation portion 700, and a cassette CS. Also, the light emitting element transfer system may further include a controller that controls each component. The controller may be connected to each component, for example, the stage module STG, the alignment portion 300, the bonding portion 400, and the second transfer portion 600, and may control the operation of each component.

The stage module STG may include a stage 312, a stage driving member 322, and a protrusion member 342.

The stage 312 may be equipped with a built-in heater 312-h. The heater may be configured to generate heat, for example, by an electric heater. The heater conducts heat through the stage 312 to heat the first substrate TS supported on the stage 312. The temperature of the first substrate TS or its bonding surface may be controlled By controlling the amount of heat generated by the heater.

The stage 312 may have an area such that the first tray TR1 and the second tray TR2 are disposed side by side. On the other hand, the stage driving member 322 may be disposed wider than the stage 312 to overlap the alignment area AE and the bonding area BDE. The stage 312 may be movable on the stage driving member 322.

A plurality of holding mechanisms 315, for example, electrostatic chucks, may be disposed on the top surface of the stage 312 to hold the first tray TR1 so that it does not move during the alignment process.

The protrusion member 342 may be disposed in a groove formed on the top surface of the stage 312 and may protrude above the top surface of the stage 312. When the protrusion member 342 protrudes, the first substrate TS disposed on the top surface of the protrusion member 342 may be raised and lowered in a vertical direction (third direction). For example, one or more protrusion member s 342 may be disposed on the periphery of the stage 312 in a pin shape. When the protrusion member 342 protrudes toward the top surface of the stage 312, the first substrate TS disposed on the top surface of the stage 312 may be separated from the top surface of the stage 312 so that at least a portion of the back surface of the first tray TR1 may be in a floating state (a state in the air).

The stage driving member 322 is disposed below the stage 312 and may be precisely moved in the first direction DR1 and the second direction DR2 . The stage driving member 322 may not move in the vertical direction.

The stage driving member 322 may be widely disposed not only in the alignment area AE but also in the bonding area BDE within the vacuum chamber VC. Therefore, the stage 312 may be moved not only in the alignment area AE but also in the bonding area BDE.

The alignment portion 302 may include a holding member 350, a second lifting member 360, a second driving member 370, and a vision member 380.

The bonding portion 402 may include a pressure member 440-1, and a laser member 450.

The pressure member 440-1 may include a pressure plate 441, a support portion 442, a window 444, and a pressure driving portion 445.

At least a portion of the pressure plate 441 may be made of a transparent material. Accordingly, light emitted from the laser member 450 may be transmitted through the transparent material of the pressure member 440. As a transparent material, quartz, glass, or ceramic materials are preferably used. The transparent material need not be transparent to the naked eye but need only consist of a material that transmits light emitted by the light source.

The support portion 442 may support the pressure plate 441 while connecting the pressure plate 441 and the pressure driving portion 445. The support portion 442 may be attached to a portion of an outer surface of the pressure plate 441 but is not limited thereto.

The pressure driving portion 445 is disposed so as not to overlap the direction of travel of the laser light and may be disposed on the outside of the vacuum chamber VC.

The pressure driving portion 445 enables the pressure plate 441 to pressurize a component disposed below the pressure plate 441 by moving downward. For example, the pressure plate 441 may be disposed overlapping the stage 312 to pressurize the first substrate TS to which the second substrate DS disposed on the stage 312 is bonded. When pressurized, the laser member 450 may emit a laser beam toward the first substrate TS.

The window 444 may be disposed on top surface (ceiling) of the vacuum chamber VC. The window 444 may be disposed to overlap the bonding region BDE of the vacuum chamber VC.

The window 444 may be made of a transparent material that can transmit a laser beam emitted from the laser member 450. The laser beam emitted from the laser member 450 disposed outside the vacuum chamber VC may enter into the vacuum chamber VC through the window 444.

The window 444 may be disposed between the laser member 450 and the pressure plate 441. That is, the window 444 may be disposed to overlap the laser member 450 and the pressure plate 441.

At least a portion of the window 444 may be made of a transparent material. As transparent materials, it is preferable to use quartz, glass materials, and ceramic materials. The material need not appear transparent to the naked eye but need only be composed of a material that transmits light emitted from a light source.

The window 444 may have a planar shape, such as a rectangular shape. Additionally, the window 444 may have a circular planar shape but is not limited thereto.

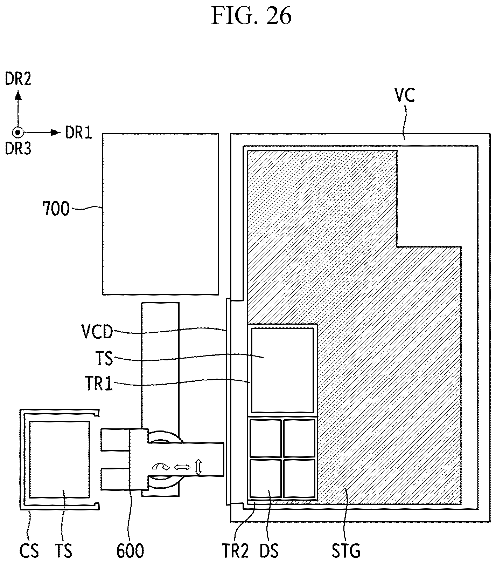

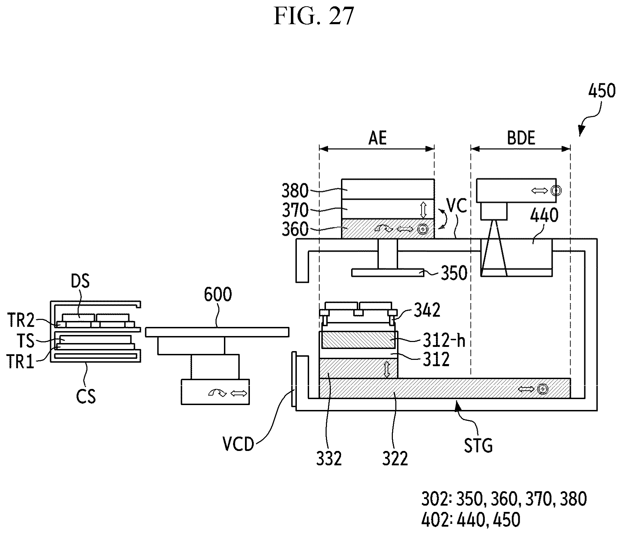

FIG. 26 is a schematic plan view illustrating a light emitting element transfer system according to another embodiment. FIG. 27 is a side view of the light emitting element transfer system of FIG. 26.

The most significant difference between FIGS. 26 and 27 is that the first transfer portion 501 is not disposed in the vacuum chamber VC. The stage 312 of the alignment area AE is equipped with a heater, and thus also functions as a stage of the bonding area, and the width of the door VCD corresponds to the width of the stage 310, which is different from the embodiment of FIGS. 17 and 18. In FIGS. 26 and 27, descriptions that overlap with the embodiment of FIGS. 17 and 18 will be omitted, and differences from the embodiment of FIGS. 17 and 18 will be mainly described.

Referring to FIGS. 26 and 27, a light emitting element transfer system includes a vacuum chamber VC, a stage module STG, an alignment portion 302, and a bonding portion 402, and may further include a transfer portion 600, a separation portion 700, and a cassette CS. Also, the light emitting element transfer system may further include a controller that controls each component. The controller may be connected to each component, for example, the stage module STG, the alignment portion 300, the bonding portion 400, and the second transfer portion 600, and may control the operation of each component.

The stage module STG may include a stage 312, a stage driving member 322, a stage lifting member 332, and a protrusion member 342.

The stage 312 may be equipped with a built-in heater 312-h. The heater may be configured to generate heat, for example, by an electric heater. The heater conducts heat through the stage 312 to heat the first substrate TS supported on the stage 312. The temperature of the first substrate TS or its bonding surface may be controlled By controlling the amount of heat generated by the heater.

A plurality of holding mechanisms 315, for example, electrostatic chucks, may be disposed on the top surface of the stage 312 to hold the first tray TR1 so that it does not move during the alignment process.

The protrusion member 342 may be disposed in a groove formed on the top surface of the stage 312 and may protrude above the top surface of the stage 312. When the protrusion member 342 protrudes, the first substrate TS disposed on the top surface of the protrusion member 342 may be raised and lowered in a vertical direction (third direction). For example, one or more protrusion member s 342 may be disposed on the periphery of the stage 312 in a pin shape. When the protrusion member 342 protrudes toward the top surface of the stage 312, the first substrate TS disposed on the top surface of the stage 312 may be separated from the top surface of the stage 312 so that at least a portion of the back surface of the first tray TR1 may be in a floating state (a state in the air).

The stage driving member 322 is disposed below the stage 312 and may be precisely moved in the first direction DR1 and the second direction DR2. The stage driving member 322 may not move in a vertical direction (i.e., the third direction DR3).

The stage driving member 322 may be widely disposed not only in the alignment area AE but also in the bonding area BDE inside the vacuum chamber VC. Therefore, the stage 312 may move not only in the alignment area AE but also in the bonding area BDE.

The stage lifting member 332 may be disposed on the sides or underneath the stage 312 to raise and lower the stage 312. The stage lifting member 332 may include a lifting cylinder or the like.

In another embodiment, the alignment portion 302 may not include the second lifting member 360. Accordingly, the holding member 350 may be movable in the first direction DR1 and the second direction DR2 and rotated around an axis parallel to the third direction DR3 by the second driving member 370, but may not be movable in a vertical direction (i.e., the third direction DR3).

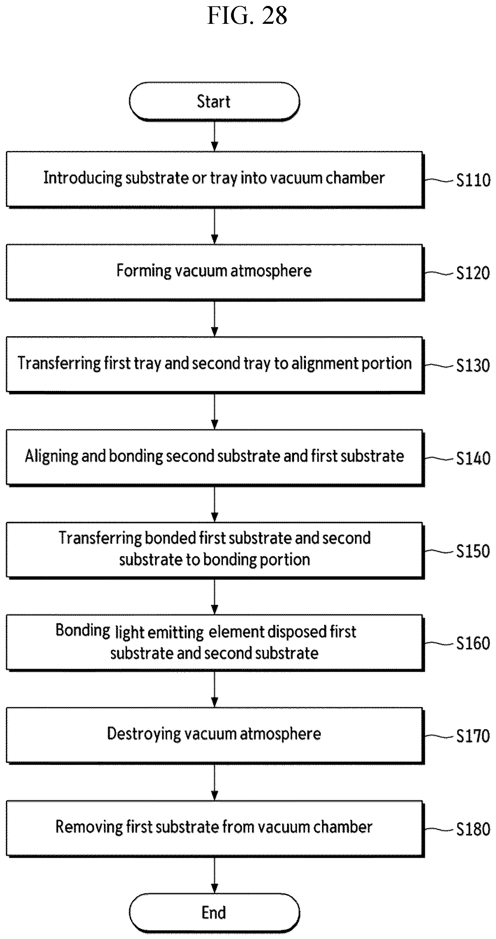

FIG. 28 is a flow chart to illustrate a light emitting element transfer method using a transfer device according to one embodiment.

The transfer device described with reference to FIG. 28 may be the transfer device described with reference to FIGS. 6 to 23.

The second transfer portion 600 supplies the first substrate TS1 or the trays TR1 and TR2 to the vacuum chamber. (S110 in FIG. 28)

As shown in FIGS. 6, 11, to 16, when the transfer device includes the loading portion 200, the second transfer portion 600 transfers the first substrate TS1 or the trays TR1 and TR2 to the stage 210 of the loading portion 200 into the vacuum chamber.

The first substrate TS1 may be transferred together with the first tray TR1 while being disposed on the first tray TR1. In another embodiment, the first substrate TS1 may be transferred as is without the first tray TR1.

Meanwhile, as shown in FIGS. 17 to 23, when the transfer device does not include the loading portion 200, the second transfer portion 600 transfers the first substrate TS1 or the trays TR1 and TR2 to the top surface of the stage of the alignment portion 300.

The vacuum chamber VC makes the inside of the vacuum chamber vacuum. (S120 in FIG. 28)

For example, the vacuum chamber VC may be maintained as a vacuum by a vacuum pump and a vacuum valve.

The first transfer portion 500 transfers to the alignment portion 300. (S130 in FIG. 28)

The first transfer portion 500 may be a vacuum robot. The vacuum robot may include a servo motor that may be used in a vacuum state and a three-axis or four-axis arm. The first transfer portion 500 may include one arm or a dual arm.

As shown in FIGS. 6, 11, and 16, the first transfer portion 500 may transfer the first substrate TS1 or the trays TR1 and TR2 from the stage 210 of the loading portion 200 to the alignment portion 300 when the first substrate TS or the trays TR1 and TR2 are loaded on the stage 210 of the loading portion 200.

For example, the first tray TR1 or the first substrate TS (on which the first substrate TS is placed) may be disposed on the stage 310 (e.g., UVW stage) of the alignment portion 300.

In addition, the first transfer portion 500 contacts the back surface of one of the plurality of second substrates DS disposed on the second tray TR2 with the holding member 350. A plurality of light emitting elements are disposed on one side of the second substrate DS, and the back side means a side facing the one side.

Then, the second substrate DS and the first substrate TS are aligned and bonded together (S140 in FIG. 28).

The holding member 350 adsorbs or grips the second substrate DS that is in contact. For example, electricity may be applied to the holding member 350 so that the back side of the second substrate DS may be adsorbed by the holding member 350 through an electrostatic chuck. In this case, the plurality of light emitting elements disposed on one side of the second substrate DS may be disposed to face the stage 310.

The first lifting member 320 of the alignment portion 300 is raised or the protrusion member 340 is lowered to bring the stage 310 and the first tray TR1 or the first substrate TS into contact. A holding mechanism 315 such as an electrostatic chuck of the stage 310 adsorbs or holds the first tray TR1 or the first substrate TS (where the first substrate TS is placed).

Then, the second lifting member 360 lowers the holding member 350 and the first substrate TS and the second substrate DS are aligned by the UVW stage. For example, the alignment markers of the first substrate TS and the second substrate DS are checked by the vision membrer 380, and the UVW stage moves the first substrate TS to match the positions of the alignment markers of the first substrate TS and the second substrate DS, thereby aligning the first substrate TS and the second substrate DS.

After aligning the first substrate TS and the second substrate DS, the adsorption or holding state of the holding member 350 is released. In this way, the second substrate DS is detached from the holding member 350 and the first substrate TS and the second substrate DS are bonded.

The other second substrates DS on the second tray TR2 are all aligned to other areas of the first substrate TS and bonded.

When one second substrate DS is bonded, the first transfer portion 500 may adjust the position of the first substrate TS before another new second substrate DS is bonded. For example, the first transfer portion 500 may adjust the position of the first substrate TS so that the next alignment area on the first substrate TS overlaps the holding member 350 when the first substrate TS is a large substrate. When the first transfer portion 500 adjusts the position of the first substrate TS, the electrostatic chuck of the stage 310 releases the adsorption or gripping state, and when the position adjustment of the first substrate TS is completed, the electrostatic chuck of the stage 310 adsorbs or grips the first substrate TS.

Then, the stage 310 is lowered below the protrusion member 340 by the first lifting member 320 or the protrusion member 340 is protruded so that the protrusion member 340 protrudes above the stage 310. As a result, the first substrate TS bonded to the second substrate DS is supported by the protrusion member 340 and becomes a floating state.

The first transfer portion 500 transfers the first substrate TS bonded to the second substrate DS to the bonding portion 400. (S150 in FIG. 28).

At this time, if the first substrate TS is disposed on the first tray TR1, the first transfer portion 500 may transfer the first tray TR1 with the first substrate TS contained in the first tray TR1 to the bonding portion 400 and place it on the stage of the bonding portion 400.

The alignment portion 300 has a driving module (the first lifting member 320 and the first driving member 330) that is suitable for precise alignment adjustment but has a small load that may be withstood. On the other hand, the drive module (the lifting member 420) of the bonding portion 400 has a high load that may be withstood, but early adjustment is difficult.

Therefore, as in one embodiment, using the alignment portion 300 and the bonding portion 400 separately, has the advantage of being able to withstand strong pressures for precise alignment and bonding. Furthermore, since the alignment portion 300 and the bonding portion 400 are located within one vacuum chamber, the alignment process and bonding process may be performed continuously in a high vacuum environment, thereby increasing production efficiency.

The bonding portion 400 applies heat and pressure to bond the light emitting elements disposed on the plurality of second substrates DS to the first substrate TS. (S160 in FIG. 28)

For example, the electrostatic chuck 415 of the heating stage 410 of the bonding portion 400 lifts the lifting member 420 or inserts the protrusion member 430 into the groove to bring the stage 310 and the first tray TR1 or the first substrate TS into contact with the top surface of the heating stage 410. A holding mechanism 415 such as the electrostatic chuck of the heating stage 410 adsorbs or grips the first tray TR1 or the first substrate TS (where the first substrate TS is placed).

The lifting member 420 lifts and brings the second substrate DS bonded to the first substrate TS into contact with the pressure member 440. The pressure member 440 pressurizes the first substrate TS bonded to the second substrate DS.

A heater built into the heating stage 410 is activated to apply heat to the first substrate TS bonded to the second substrate DS.

If necessary, a laser member 450 irradiates a laser to the first substrate TS bonded to the second substrate DS or the boundary between the second substrate DS and the first substrate TS from above the pressure member 440.

The laser member 450 may be implemented in various laser irradiation methods, such as a method of continuously irradiating a specific area or a method of scanning.

In this way, the light emitting element of the second substrate DS and the first substrate TS may be bonded by applying heat and pressure to the first substrate TS bonded to the second substrate DS.

Then, when bonding is completed, the heating stage 410 is lowered below the protrusion member 430 by the lifting member 420 or the protrusion member 430 is protruded so that the protrusion member 430 protrudes above the heating stage 410. As a result, the first substrate TS bonded to the second substrate DS is supported by the protrusion member 430 and floats from the top surface of the heating stage 410.

The first transfer portion 500 unloads the first substrate TS bonded to the second substrate DS. For example, as shown in FIGS. 6, 11, and 16, when the transfer device includes a loading portion 200, the first transfer portion 500 transfers the first substrate TS bonded to the second substrate DS to a stage 210 of the loading portion 200.

When the transfer device does not include the loading portion 200, the first transfer portion 500 transfers the first substrate TS bonded to the second substrate DS to the stage top surface of the alignment portion 300.

A vacuum chamber VC removes the vacuum atmosphere inside the vacuum chamber. (S170 in FIG. 28)

The second transfer portion 600 removes the first substrate TS bonded to the second substrate DS from the vacuum chamber VC. (S180 in FIG. 28)

The first substrate TS1 may be placed on the first tray TR1 and transferred together with the first tray TR1. In another embodiment, the first substrate TS1 may be transferred as is without the first tray TR1.

The second transfer portion 600 may transfer the removed second substrate DS and the bonded first substrate TS to the separation portion 700. The second transfer portion 600 may separate the second substrate DS from the first substrate TS that has been removed. Since the adhesive force between the second substrate DS and the light emitting element LE disposed on the second substrate DS is much weaker than the adhesive force between the light emitting element LE and the first substrate TS, the second substrate DS and the light emitting element LE may be easily separated by an external force. Furthermore, the first substrate TS and the first tray TR1 may be separated from each other.

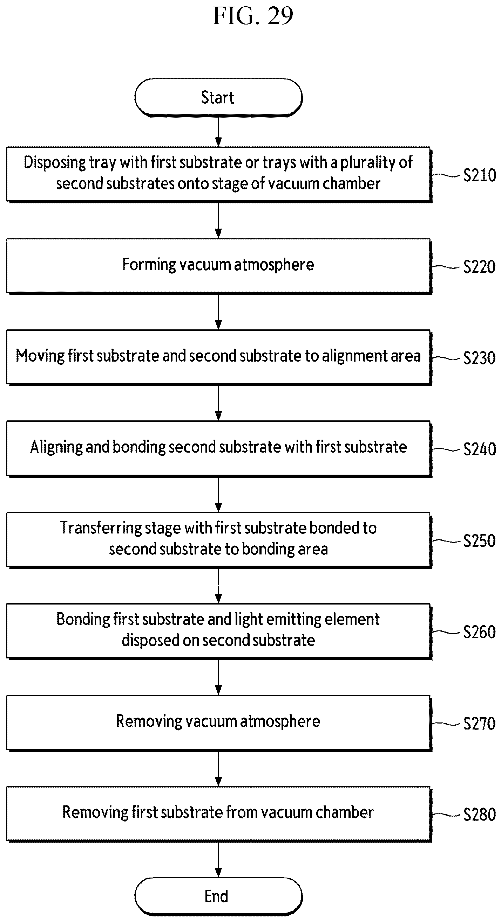

FIG. 29 is a flow chart to illustrate a light emitting element transfer method using a transfer device according to one embodiment.

The transfer device described with reference to FIG. 29 may be the transfer device described with reference to FIGS. 24 to 27.

The second transfer portion 600 loads a first tray TR1 on which the first substrate TS is disposed or a tray TR2 on which a plurality of second substrates DS are disposed onto the stage 312 of the stage module STG of the vacuum chamber VC. (S210 in FIG. 29)

As shown in FIGS. 24 to 27, the second transfer portion 600 transfers the first substrate TS1 or trays TR1 and TR2 onto the top surface of the stage 312 of the stage module STG.

The first substrate TS1 may be disposed on the first tray TR1 and transferred together with the first tray TR1. In another embodiment, the first substrate TS1 may be transferred as is without the first tray TR1.

The vacuum chamber VC makes the inside of the vacuum chamber into a vacuum state. (S220 in FIG. 29)

For example, the vacuum chamber VC may be maintained in a vacuum state by a vacuum pump and a vacuum valve.

The stage module STG transfers the substrates TS1 and TS2) or the trays TR1 and TR2 to the alignment area AE. (S230 in FIG. 29)

The stage 312 is moved on the stage driving member 322 to place the first tray TR1 or the first substrate TS in the alignment area AE.

The protrusion member 340 of the stage module STG is lowered to bring the stage 312 into contact with the first tray TR1 or the first substrate TS.

A holding mechanism 315 such as an electrostatic chuck of the stage 312 adsorbs or grips the first tray TR1 or the first substrate TS (where the first substrate TS is placed).

Then, the second substrate DS and the first substrate TS are aligned and bonded together (S240 in FIG. 29).

For example, the second lifting member 360 lowers the holding member 350, and the second driving member 370 moves the holding member 350 to align the first substrate TS and the second substrate DS. For example, the alignment markers of the first substrate TS and the second substrate DS are checked by the vision membrer 380, and the second driving member 370 moves the holding member 350 to match the positions of the alignment markers of the first substrate TS and the second substrate DS, thereby aligning the first substrate TS and the second substrate DS.

After aligning the first substrate TS and the second substrate DS, the adsorption or gripping state of the holding member 350 is released. In this way, the second substrate DS is detached from the holding member 350 and the first substrate TS and the second substrate DS are bonded.

The other second substrates DS on the second tray TR2 are all aligned to other areas of the first substrate TS and bonded.

When one second substrate DS is bonded, the stage module STG may adjust the position of the first substrate TS before another new second substrate DS is bonded. For example, when the first substrate TS is a large substrate, the stage module STG may adjust the position of the first substrate TS so that the next alignment area of the first substrate TS overlaps the holding member 350. As a result, the second substrate DS may be bonded to the entire first substrate TS.

The stage module STG transfers the first substrate TS bonded to the second substrate DS to the bonding area BDE. (S250 in FIG. 29).

For example, the stage 312 is moved on the stage driving member 322 to transfer the first tray TR1 or the first substrate TS to the bonding area BDE.

In the bonding area BDE, the light emitting elements disposed on the plurality of second substrates DS are bonded to the first substrate TS. (S260 in FIG. 29)

As shown in FIG. 24 and FIG. 25, when the pressure member 440-1 includes the pressure driving portion 445, the pressure member 440-1 is lowered in the bonding area BDE to bring the second substrate DS bonded to the first substrate TS into contact with the pressure member 440-1. The pressure member 440-1 presses the first substrate TS bonded to the second substrate DS.

On the other hand, as shown in FIGS. 26 and 27, when the pressure member 440-1 does not include the pressure driving portion 445, and the stage module STG includes the stage lifting member 332, the stage lifting member 332 is raised to bring the second substrate DS bonded to the first substrate TS into contact with the pressure member 440-1. The pressure member 440 pressurizes the first substrate TS bonded to the second substrate DS.

Thereafter, the heater built into the stage 312 is operated to apply heat to the first substrate TS bonded to the second substrate DS.

If necessary, the laser member 450 irradiates the laser to the first substrate TS bonded to the second substrate DS or the boundary between the second substrate DS and the first substrate TS above the pressure member 440-1. The laser light emitted from the laser member 450 may be transmitted through the window 444 and the pressure plate 441 of the pressure member 440-1 to be irradiated to the first substrate TS bonded to the second substrate DS or to the boundary between the second substrate DS and the first substrate TS.

The laser member 450 may be implemented in various laser irradiation methods, such as a method of continuously irradiating a specific area or a method of scanning.

In this way, the light emitting element of the second substrate DS and the first substrate TS may be bonded by applying heat and pressure to the first substrate TS bonded to the second substrate DS.

The vacuum chamber VC removes the vacuum atmosphere inside the vacuum chamber. (S270 in FIG. 28)

The second transfer portion 600 removes the first substrate TS bonded with the second substrate DS from the vacuum chamber VC. (S280 in FIG. 29)

The first substrate TS1 may be disposed on the first tray TR1 and transferred together with the first tray TR1. In another embodiment, the first substrate TS1 may be transferred as is without the first tray TR1.

The second transfer portion 600 may transfer the removed second substrate DS and the bonded first substrate TS to the separation portion 700. The second transfer portion 600 may separate the second substrate DS from the first substrate TS that has been removed. Since the adhesive force between the second substrate DS and the light emitting element LE disposed on the second substrate DS is much weaker than the adhesive force between the light emitting element LE and the first substrate TS, the second substrate DS and the light emitting element LE may be easily separated by an external force. Furthermore, the first substrate TS and the first tray TR1 may be separated from each other.

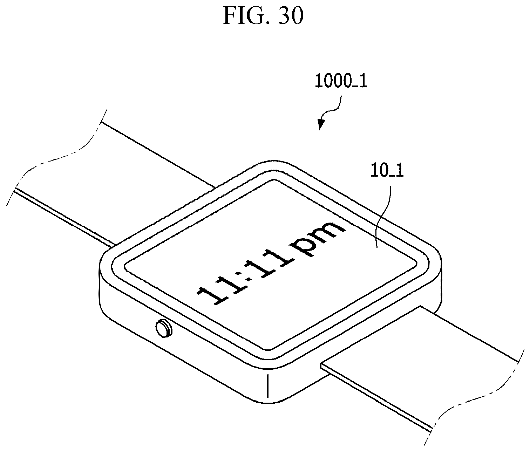

FIG. 30 is an exemplary drawing illustrating a smart watch including a display device according to one embodiment.

Referring to FIG. 30, the display device 10_1 according to one embodiment may be applied to a smart watch 1000_1, which is one of smart devices.

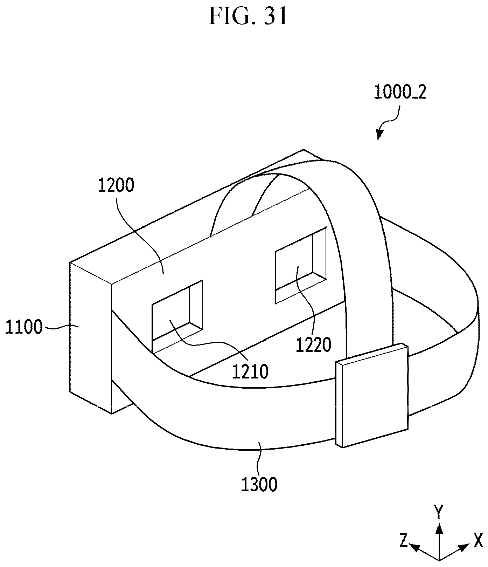

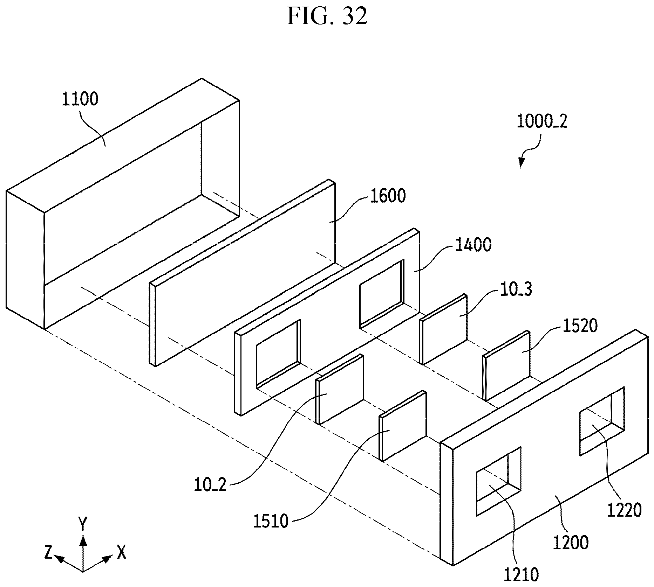

FIGS. 31 and 32 are exemplary drawings illustrating a virtual reality device including a display device according to one embodiment.

Referring to FIGS. 31 and 32, a head-mounted display device 1000_2 according to one embodiment includes a first display device 10_2, a second display device 10_3, a display device storage portion 1100, a storage portion cover 1200, a first eyepiece lens 1210, a second eyepiece lens 1220, a head-mounted band 1300, a middle frame 1400, a first optical member 1510, a second optical member 1520, and a control circuit board 1600.

The first display device 10_2 provides an image to the user's left eye, and the second display device 10_3 provides an image to the user's right eye. Since each of the first display device 10_2 and the second display device 10_3 is substantially the same as the display device 10 described in connection with FIG. 1 and FIG. 2, the description of the first display device 10_2 and the second display device 10_3 will be omitted.

The first optical member 1510 may be disposed between the first display device 10_2 and the first eyepiece lens 1210. The second optical member 1520 may be disposed between the second display device 10_3 and the second eyepiece lens 1220. Each of the first optical member 1510 and the second optical member 1520 may include at least one convex lens.

The middle frame 1400 may be disposed between the first display device 10_2 and the control circuit board 1600 and may be disposed between the second display device 10_3 and the control circuit board 1600. The middle frame 1400 serves to support and fix the first display device 10_2, the second display device 10_3, and the control circuit board 1600.

The control circuit board 1600 may be disposed between the middle frame 1400 and the display device storage portion 1100. The control circuit board 1600 may be connected to the first display device 10_2 and the second display device 10_3 through a connector. The control circuit board 1600 may convert an image source input from the outside into digital video data DATA and transmit the digital video data DATA to the first display device 10_2 and the second display device 10_3 through the connector.

The control circuit board 1600 may transmit digital video data DATA corresponding to a left-eye image optimized for the user's left eye to the first display device 10_2, and digital video data DATA corresponding to a right-eye image optimized for the user's right eye to the second display device 10_3. Alternatively, the control circuit board 1600 may transmit the same digital video data DATA to the first display device 10_2 and the second display device 10_3.

The display device storage portion 1100 serves to store the first display device 10_2, the second display device 10_3, the middle frame 1400, the first optical member 1510, the second optical member 1520, and the control circuit board 1600. The storage portion cover 1200 is disposed to cover an open surface of the display device storage portion 1100. The storage portion cover 1200 may include a first eyepiece lens 1210 for the user's left eye and a second eyepiece lens 1220 for the user's right eye. In FIGS. 37 and 38, the first eyepiece lens 1210 and the second eyepiece lens 1220 are separately disposed, but the embodiment of the present disclosure is not limited thereto. The first eyepiece lens 1210 and the second eyepiece lens 1220 may be combined into one.

The first eyepiece lens 1210 may be aligned with the first display device 10_2 and the first optical member 1510, and the second eyepiece lens 1220 may be aligned with the second display device 10_3 and the second optical member 1520. Accordingly, the user may view the image of the first display device 10_2 magnified into a virtual image by the first optical member 1510 through the first eyepiece lens 1210 and may view the image of the second display device 10_3 magnified into a virtual image by the second optical member 1520 through the second eyepiece lens 1220.

The head-mounted band 1300 serves to secure the display device storage portion 1100 to the user's head so that the first eyepiece lens 1210 and the second eyepiece lens 1220 of the storage portion cover 1200 may be maintained in a state where they are respectively arranged on the user's left and right eyes. If the display device storage portion 1100 is implemented as lightweight and compact, the head-mounted display device 1000 may be equipped with a glasses frame as shown in FIG. 31 instead of the head-mounted band 800.

In addition, the head-mounted display device 1000 may further be equipped with a battery for supplying power, an external memory slot for storing external memory, and an external connection port and a wireless communication module for receiving a video source. The external connection port may be a universe serial bus (USB) terminal, a display port, or a high-definition multimedia interface (HDMI) terminal, and the wireless communication module may be a 5G communication module, a 4G communication module, a wifi module, or a Bluetooth module.

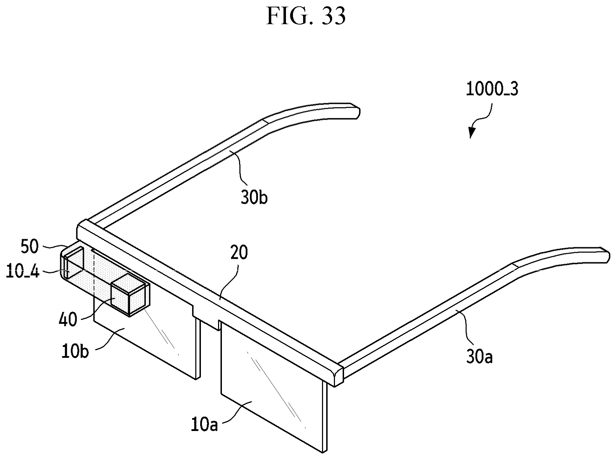

FIG. 33 is an exemplary drawing illustrating a virtual reality device including a display device according to another embodiment. FIG. 33 illustrates a virtual reality device 1000_3 to which a display device 10_4 according to one embodiment is applied.

Referring to FIG. 33, a virtual reality device 1000_3 according to one embodiment may be a device in the form of glasses. The virtual reality device 1000_3 according to one embodiment may include a display device 10_4, a left-eye lens 10a, a right-eye lens 10b, a support frame 20, eyeglass frame legs 30a and 30b, a reflective member 40, and a display device storage portion 50.

In FIG. 33, it is exemplified that the virtual reality device 1000_3 is a glasses-type display device including eyeglass frame legs 30a and 30b. That is, the virtual reality device 1000_3 according to one embodiment is not limited to that illustrated in FIG. 33 and may be applied in various forms in various other electronic devices.

The display device storage portion 50 may include a display device 10_4 and a reflective member 40. The image displayed on the display device 10_4 may be reflected from the reflective member 40 and provided to the user's right eye through the right eye lens 10b. As a result, the user may view the virtual reality image displayed on the display device 10_4 through the right eye.

In FIG. 33, the display device storage portion 50 is disposed at the right end of the support frame (20), but the embodiment of the present specification is not limited thereto. For example, the display device storage portion 50 may be disposed at the left end of the support frame 20, and in this case, the image displayed on the display device 10_4 may be reflected from the reflective member 40 and provided to the user's left eye through the left eye lens 10a. As a result, the user may view the virtual reality image displayed on the display device 10_4 through the left eye. Alternatively, the display device storage portion 50 may be disposed at both the left end and the right end of the support frame 20, in which case the user may view the virtual reality image displayed on the display device 10_4 through both the left and right eyes.

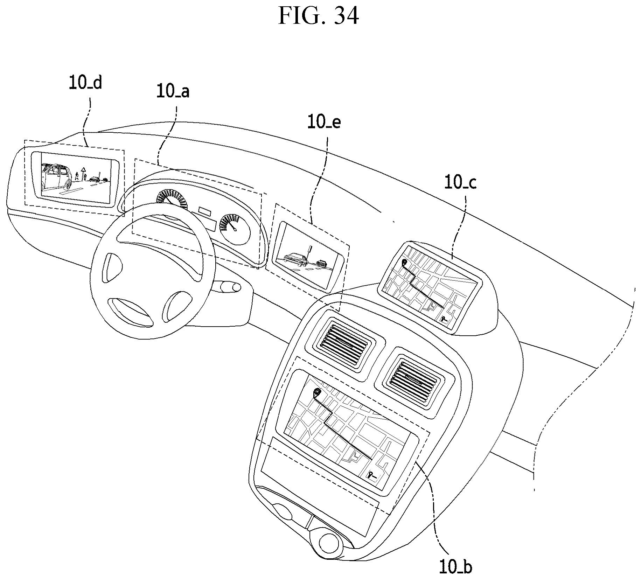

FIG. 34 is an exemplary drawing illustrating a vehicle instrument panel and center fascia including display devices according to one embodiment. FIG. 34 illustrates a vehicle to which display devices 10_a, 10_b, 10_c, 10_d, and 10_e according to one embodiment are applied.

Referring to FIG. 34, the display devices 10_a, 10_b, and 10_c according to one embodiment may be applied to an instrument panel of the vehicle, applied to the center fascia of the vehicle, or applied to a center information display (CID) disposed on the dashboard of the vehicle. Further, the display devices 10_d and 10_e according to one embodiment may be applied to a room mirror display that replaces a side mirror of a vehicle.

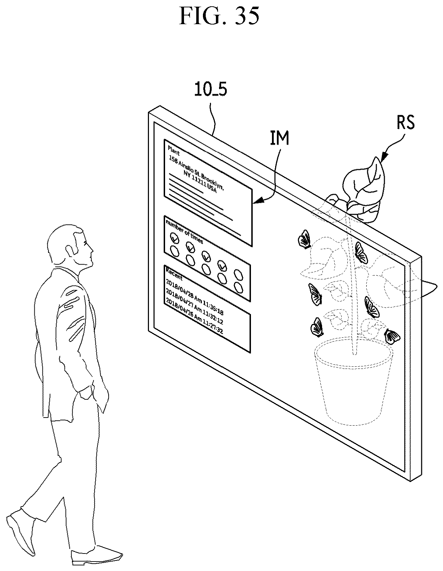

FIG. 35 is an exemplary drawing illustrating a transparent display device including a display device according to one embodiment.

Referring to FIG. 35, the display device 10_5 according to one embodiment may be applied to a transparent display device. The transparent display device may display an image IM and transmit light at the same time. Therefore, a user positioned at the front of the transparent display device may not only view the image IM displayed on the display device 10_5, but also view an object RS or background positioned at the back of the transparent display device. When the display device 10_5 is applied to a transparent display device, the substrate of the display device 10_5 may include a light transmitting portion that may transmit light or may be formed of a material that may transmit light.

Although the embodiments of the present disclosure have been described with reference to the attached drawings, the present disclosure is not limited to the embodiments described above, but may be manufactured in various different forms, and those having ordinary knowledge in the technical field to which the disclosure belongs will understand that the disclosure may be embodied in other specific forms without altering the technical idea or essential features of the disclosure. Therefore, the embodiments described above are in all respects exemplary and not limiting.

## Claims

1. A light emitting element transfer system comprising:
a vacuum chamber (VC) configured to create a vacuum atmosphere or remove the vacuum atmosphere therein;
an alignment portion (300) configured to align a first substrate (TS) and a second substrate (DS) inside the vacuum chamber (VC);
a bonding portion (400) configured to apply heat and pressure to the aligned first substrate (TS) and the second substrate (DS) and which is disposed adjacent to the alignment portion (300) in an arrangement direction (DR1) and inside the vacuum chamber (VC); and
a first transfer portion (500) movable in the vacuum chamber (VC) in the arrangement direction (DR1), configured to transfer the first substrate (TS) or the second substrate (DS) to the alignment portion (300), and to transfer the aligned first substrate (TS) and second substrate (DS) from the alignment portion (300) to the bonding portion (400).

2. The system of claim 1, wherein the alignment portion (300) includes:
a stage module having a holding mechanism (315) for preventing movement of the first substrate (TS) or a tray (TR1, TR2) on a top surface thereof and a protruding and concealable protruding member (340), and configured to support the first substrate (TS) during an alignment process;
a holding member (350) disposed on a top portion of the stage module and configured to adsorb or grip a back surface of the second substrate (DS) to support the second substrate (DS) on a top portion of the first substrate (TS);
a second driving member (370) configured to move the holding member (350) in a horizontal direction (DR1, DR2); and
a vision member (380) configured to photograph an alignment of the first substrate (TS) and the second substrate (DS).

3. The system of claim 2, wherein the stage module is a UVW stage,
wherein the first transfer portion (500) is a vacuum robot.

4. The system of claim 3, wherein the vacuum robot includes a dual arm.

5. The system of any one of the preceding claims, wherein the bonding portion (400) includes,
a heating stage (410) including a holding mechanism (415), a protruding member (430), and a heater;
a lifting member (420) configured to vertically (DR3) elevate and lower the heating stage (410);
a pressure member (440) disposed on the heating stage (410) and configured to press the second substrate (DS) disposed on the heating stage (410) and to transmit laser light; and
a laser member (450) configured to emit the laser light from above the pressure member (440) to the second substrate (DS) disposed on the heating stage (410).

6. The system of any one of the preceding claims, further comprising a loading portion (200) disposed inside the vacuum chamber (VC) and into which a substrate or a tray is loaded.

7. The system of claim 6, wherein the loading portion (200) includes:
a first loading portion (200-1) into which the first substrate (TS) or a first tray (TR1) including the first substrate (TS) is loaded; and
a second loading portion (200-2) into which a second tray (TR2) including the second substrate (DS) is loaded,
wherein the substrate includes the first substrate (TS) and the second substrate (DS), and the tray includes the first tray (TR1) and the second tray (TR2).

8. The system of any one of the preceding claims, wherein the vacuum chamber (VC) includes a chamber door (VCD) located on one side, and
wherein the system is configured to allow trays (TR1, TR2) on which the first substrate (TS) or the second substrate (DS) are disposed to enter and exit the vacuum chamber (VC) through the chamber door (VCD).

9. The system of any one of the preceding claims, further comprising:
a cassette (CS) disposed outside the vacuum chamber (VC) and configured to load a tray (TR1, TR2) on which the first substrate (TS) or the second substrate (DS) is placed; and
a second transfer portion (600) disposed outside the vacuum chamber (VC) and configure to transfer the tray loaded in the cassette (CS) into the vacuum chamber (VC).

10. The system of claim 9, further comprising:
a separation portion (700) disposed outside the vacuum chamber (VC) and configured to separate and load a tray (TR1, TR2) on which the first substrate (TS) or the second substrate (DS) is placed.

11. The system of any one of claims 9 or 10, further comprising:
a controller connected to and configured to control the operation of the loading portion (200), the alignment portion (300), the bonding portion (400), the first transfer portion (500) and the second transfer portion (600).

12. A transfer method for light emitting elements comprising:
loading (S110) a first tray (TR1) on which a first substrate (TS) is disposed and a second tray (TR2) on which a plurality of second substrates (DS) are disposed, into a vacuum chamber (VC) by a second transfer portion (600);
making (S120) an inside of the vacuum chamber (VC) into a vacuum state;
transferring (S130) the first tray (TR1) and the second tray (TR2) to an alignment portion (300);
aligning (S140) and bonding the plurality of second substrates (DS) disposed on the second tray (TR2) one by one to the first substrate (TS) disposed on the first tray (TR1) in the alignment portion (300);
transferring (S150) the first tray (TR1) on which the first substrate (TS) bonded to the second substrates (DS) is disposed, to a bonding portion (400) by a first transfer portion (500);
applying (S160) heat and pressure to the first substrate (TS) bonded to the second substrates (DS) in the bonding portion (400) to bond the light emitting elements disposed on the second substrates (DS) to the first substrate (TS); and
removing (S170) the vacuum atmosphere from the vacuum chamber (VC).

13. The method of claim 12, the transferring (S130) to the alignment portion (300) comprises,
disposing the first tray (TR1) on a UVW stage of the alignment portion (300); and
adsorbing or gripping a second substrate (DS) of one of the plurality of second substrates (DS) disposed on the second tray (TR2) with a holding member (350).

14. The method of claim 13, the aligning (S140) and bonding comprises,
adsorbing the first tray (TR1) on a top surface of the UVW stage using a holding mechanism (315);
moving the UVW stage while lowering the holding member (350) to align the first tray (TR1) and the second tray (TR2); and
causing a second holding member (350) to stop adsorbing or gripping the second substrate (DS) to bond the second substrate (DS) onto the first substrate (TS).

15. The method of any one of claims 12 to 14, the method further comprising:
removing (S180) the first substrate (TS) bonded to the second substrate (DS) from the vacuum chamber (VC) using the second transfer portion (600).
